# EUROPEAN PATENT APPLICATION

(11) **EP 4 648 581 A1**
(43) Date of publication of application: **12.11.2025**
(21) Application number: 25160363.5
(22) Date of filing: 26.02.2025
(51) Int. Cl.: H10H 29/85, H10H 29/80, H10H 29/39, H10H 29/49

(54) **DISPLAY DEVICE, ELECTRONIC DEVICE AND METHOD OF MANUFACTURING DISPLAY DEVICE**

(30) Priority: 08.05.2024 KR 20240060795
(71) Applicant: Samsung Display Co., Ltd., Yongin-si, Gyeonggi-do 17113 (KR)
(72) Inventor: SIM, Young Chul, 17113 Yongin-si (KR); KIM, Jun Youn, 17113 Yongin-si (KR); CHOI, Byeong Hwa, 17113 Yongin-si (KR)
(74) Representative: Walaski, Jan Filip

(57) **Abstract**

A display device includes: a first subpixel; a second subpixel; a pixel circuit layer including a pixel circuit; a first subpixel area formed by the first subpixel; a second subpixel area formed by the second subpixel; a 1-1 light-emitting element on the pixel circuit layer, a 1-2 light-emitting element on the 1-1 light-emitting element, and a 1-3 light-emitting element on the 1-2 light-emitting element, wherein the 1-1 light-emitting element, the 1-2 light-emitting element, and 1-3 light-emitting element are in the first sub-pixel area; and a 2-1 light-emitting element on the pixel circuit layer, a 2-2 light-emitting element on the 2-1 light-emitting element, and a 2-3 light-emitting element on the 2-2 light-emitting element, wherein the 2-1 light-emitting element, the 2-2 light-emitting element, and the 2-3 light-emitting element are in the second subpixel area, wherein the 1-3 light-emitting element is not electrically connected to the pixel circuit.

## Description

### CROSS-REFERENCE TO RELATED APPLICATION

The present application claims priority to Korean Patent Application No. 10-2024-0060795, filed on 8 May 2024 in the Korean Intellectual Property Office.

### BACKGROUND

### 1. Field

The present disclosure relates to a display device, electronic device, and a method of manufacturing the display device.

### 2. Description of the Related Art

As information technologies develop, the importance of display devices, which are connecting media between users and information, is emerging. Accordingly, research and development on display devices is continuously being conducted.

A display device may need to have high resolution to display a high-quality image (or video).

The above information disclosed in this Background section is only for enhancement of understanding of the background and therefore the information discussed in this Background section does not necessarily constitute prior art.

### SUMMARY

Aspects of some embodiments of the present disclosure include a display device that may be capable of displaying relatively high-resolution images, and a method of manufacturing the display device.

Aspects of some embodiments of the present disclosure include a display device and a method of manufacturing the display device that may be capable of increasing light efficiency and relatively simplifying manufacturing processes.

According to some embodiments of the present disclosure, a display device includes a first subpixel and a second subpixel, the display device including a pixel circuit layer including a pixel circuit, a first subpixel area formed by the first subpixel, a second subpixel area formed by the second subpixel, a 1-1 light-emitting element on the pixel circuit layer, a 1-2 light-emitting element on the 1-1 light-emitting element, and a 1-3 light-emitting element on the 1-2 light-emitting element, wherein the 1-1 light-emitting element, the 1-2 light-emitting element, and 1-3 light-emitting element are in the first sub-pixel area, and a 2-1 light-emitting element on the pixel circuit layer, a 2-2 light-emitting element on the 2-1 light-emitting element, and a 2-3 light-emitting element on the 2-2 light-emitting element, wherein the 2-1 light-emitting element, the 2-2 light-emitting element, and the 2-3 light-emitting element are in the second subpixel area, wherein the 1-3 light-emitting element may not be electrically connected to the pixel circuit.

According to some embodiments, the 2-2 light-emitting element may not be electrically connected to the pixel circuit, and the 1-1 light-emitting element, the 1-2 light-emitting element, the 2-1 light-emitting element, and the 2-3 light-emitting element may be electrically connected to the pixel circuit.

According to some embodiments, the display device may further include a 1-1 electrode configured to electrically connect the pixel circuit and the 1-1 light-emitting element, a 1-2 electrode configured to electrically connect the pixel circuit and the 1-2 light-emitting element, a 2-1 electrode configured to electrically connect the pixel circuit and the 2-1 light-emitting element, and a 2-2 electrode configured to electrically connect the pixel circuit and the 2-3 light-emitting element, wherein the 1-2 electrode may not overlap the 1-1 light-emitting element in a plan view.

According to some embodiments, the display device may further include a first interlayer insulating layer of which at least a portion is between the 1-1 light-emitting element and the 1-2 light-emitting element and between the 2-1 light-emitting element and the 2-2 light-emitting element, and a second interlayer insulating layer of which at least a portion is between the 1-2 light-emitting element and the 1-3 light-emitting element and between the 2-2 light-emitting element and the 2-3 light-emitting element, wherein the second interlayer insulating layer may entirely cover a lower surface of the 1-3 light-emitting element and may expose at least a portion of a lower surface of the 2-3 light-emitting element.

According to some embodiments, the display device may further include a first insulating layer surrounds the 1-1 light-emitting element and the 2-1 light-emitting element, a second insulating layer surrounds the 1-2 light-emitting element and the 2-2 light-emitting element, and a third insulating layer surrounds the 1-3 light-emitting element and the 2-3 light-emitting element, wherein the 1-2 electrode may pass through the first insulating layer, and the 2-2 electrode may pass through the first insulating layer and the second insulating layer.

According to some embodiments, the display device may further include a first electrode and a second electrode electrically connected to the pixel circuit, wherein the second electrode may not overlap the 1-1 light-emitting element and the 2-1 light-emitting element in a plan view, the first electrode may be an anode, and the second electrode may be a cathode.

According to some embodiments, the display device may further include a first insulating layer configured to surround the 1-1 light-emitting element and the 2-1 light-emitting element, a second insulating layer configured to surround the 1-2 light-emitting element and the 2-2 light-emitting element, and a third insulating layer configured to surround the 1-3 light-emitting element and the 2-3 light-emitting element, wherein the second electrode may pass through the first insulating layer, the second insulating layer, and the third insulating layer.

According to some embodiments, the display device may further include a first conductive layer configured to electrically connect the second electrode and the 1-1 light-emitting element, a second conductive layer configured to electrically connect the second electrode and the 1-2 light-emitting element, and a third conductive layer configured to electrically connect the second electrode and the 1-3 light-emitting element, wherein each of the first conductive layer, the second conductive layer, and the third conductive layer may include the same material as at least a portion of the second electrode.

According to some embodiments, each of the first conductive layer, the second conductive layer, and the third conductive layer may be integrally connected to the second electrode, and the first conductive layer, the second conductive layer, the third conductive layer, and the second conductive layer may have a mesh pattern shape in a plan view.

According to some embodiments, the first conductive layer and the second electrode may be outside areas, in which the 1-1 light-emitting element and the 2-1 light-emitting element are located, in a plan view.

According to some embodiments, the display device may further include a first connection electrode on the first conductive layer, a second connection electrode on the second conductive layer, and a third connection electrode on the third conductive layer, wherein the first connection electrode may cover an upper surface of the 1-1 light-emitting element, the second connection electrode may cover an upper surface of the 1-2 light-emitting element, and the third connection electrode may cover an upper surface of the 1-3 light-emitting element.

According to some embodiments, the 1-1 light-emitting element and the 2-1 light-emitting element may emit first light, the 1-2 light-emitting element may emit second light, and the 2-3 light-emitting element may emit third light, wherein the first light, the second light, and the third light may be pieces of light having different colors.

According to some embodiments of the present disclosure, there is a display device including a pixel circuit layer including a pixel circuit, a 1-1 light-emitting element on the pixel circuit layer, a 1-2 light-emitting element on the 1-1 light-emitting element, a 1-3 light-emitting element on the 1-2 light-emitting element, a 2-1 light-emitting element at the same layer as the 1-1 light-emitting element, a 2-2 light-emitting element at the same layer as the 1-2 light-emitting element, and a 2-3 light-emitting element at the same layer as the 1-3 light-emitting element, wherein the 1-3 light-emitting element and the 2-2 light-emitting element may not be electrically connected to the pixel circuit.

According to some embodiments, the display device may further include a first insulating layer surrounds the 1-1 light-emitting element and the 2-1 light-emitting element, a second insulating layer surrounds the 1-2 light-emitting element and the 2-2 light-emitting element, a third insulating layer surrounds the 1-3 light-emitting element and the 2-3 light-emitting element, a 1-1 electrode configured to electrically connect the pixel circuit and the 1-1 light-emitting element, a 1-2 electrode configured to electrically connect the pixel circuit and the 1-2 light-emitting element, a 2-1 electrode configured to electrically connect the pixel circuit and the 2-1 light-emitting element, and a 2-2 electrode configured to electrically connect the pixel circuit and the 2-3 light-emitting element, wherein the 1-2 electrode may pass through the first insulating layer, and the 2-2 electrode may pass through the first insulating layer and the second insulating layer.

According to some embodiments, the display device may further include a first interlayer insulating layer of which at least a portion is between the 1-1 light-emitting element and the 1-2 light-emitting element and between the 2-1 light-emitting element and the 2-2 light-emitting element, and a second interlayer insulating layer of which at least a portion is between the 1-2 light-emitting element and the 1-3 light-emitting element and between the 2-2 light-emitting element and the 2-3 light-emitting element, wherein the second interlayer insulating layer may entirely cover a lower surface of the 1-3 light-emitting element.

According to some embodiments, the display device may further include a first electrode and a second electrode electrically connected to the pixel circuit, wherein the second electrode may not overlap the 1-1 light-emitting element and the 2-1 light-emitting element in a plan view,

According to some embodiments, the first electrode may further include a 1-1 electrode configured to electrically connect the pixel circuit and the 1-1 light-emitting element, a 1-2 electrode configured to electrically connect the pixel circuit and the 1-2 light-emitting element, a 2-1 electrode configured to electrically connect the pixel circuit and the 2-1 light-emitting element, and a 2-2 electrode configured to electrically connect the pixel circuit and the 2-3 light-emitting element, wherein the 1-3 light-emitting element and the 2-2 light-emitting element may not be electrically connected to the first electrode.

According to some embodiments of the present disclosure, in a method of manufacturing a display device which includes a first subpixel area formed by a first subpixel and a second subpixel area formed by a second subpixel, the method includes forming a pixel circuit layer including a pixel circuit; in the first subpixel area, forming a 1-1 base electrode and a 1-2 base electrode electrically connected to the pixel circuit, forming a 1-1 light-emitting element on the pixel circuit layer, forming a 1-2 light-emitting element on the 1-1 light-emitting element, and forming a 1-3 light-emitting element on the 1-2 light-emitting element; and in the second subpixel area, forming a 2-1 base electrode and a 2-2 base electrode electrically connected to the pixel circuit, forming a 2-1 light-emitting element on the pixel circuit layer, forming a 2-2 light-emitting element on the 2-1 light-emitting element, and forming a 2-3 light-emitting element on the 2-2 light-emitting element, wherein the 1-1 base electrode may be electrically connected to the 1-1 light-emitting element, the 1-2 base electrode may be electrically connected to the 1-2 light-emitting element, the 2-1 base electrode may be electrically connected to the 2-1 light-emitting element, the 2-2 base electrode may be electrically connected to the 2-3 light-emitting element, and the 1-3 light-emitting element may not be electrically connected to the pixel circuit.

According to some embodiments, the method may include forming a base insulating layer on the pixel circuit layer, forming a first insulating layer on the base insulating layer, forming a first interlayer insulating layer on the first insulating layer, forming a second insulating layer on the first interlayer insulating layer, and forming a second interlayer insulating layer on the second insulating layer, wherein the forming of the first insulating layer may include depositing a first base insulating layer, etching the first base insulating layer to form a first contact opening exposing the 1-2 base electrode, and etching the first base insulating layer to form a second contact opening exposing the 2-2 base electrode, and the forming of the second insulating layer may include depositing a second base insulating layer, and etching the second base insulating layer to form a third contact opening overlapping the second contact opening.

According to some embodiments, in the forming of the 2-2 light-emitting element, the 2-2 light-emitting element may be formed such that a lower surface of the 2-2 light-emitting element is completely in contact with the first interlayer insulating layer.

An electronic device includes a processor to provide input image data; and a display device to display an image based on the input image data. The display device includes a first subpixel; a second subpixel; a pixel circuit layer including a pixel circuit; a first subpixel area formed by the first subpixel; a second subpixel area formed by the second subpixel; a 1-1 light-emitting element on the pixel circuit layer, a 1-2 light-emitting element on the 1-1 light-emitting element, and a 1-3 light-emitting element on the 1-2 light-emitting element, and a 2-1 light-emitting element on the pixel circuit layer, a 2-2 light-emitting element on the 2-1 light-emitting element, and a 2-3 light-emitting element on the 2-2 light-emitting element. The 1-1 light-emitting element, the 1-2 light-emitting element, and 1-3 light-emitting element are in the first sub-pixel area. The 2-1 light-emitting element, the 2-2 light-emitting element, and the 2-3 light-emitting element are in the second subpixel area. And the 1-3 light-emitting element is not electrically connected to the pixel circuit.

### BRIEF DESCRIPTION OF THE DRAWINGS

FIG. 1 is a schematic plan view of a display device.
FIG. 2 is a schematic plan view of a pixel.
FIG. 3 is an equivalent circuit diagram of a pixel.
FIGS. 4 and 5 are schematic cross-sectional views of a display device.
FIG. 6 is a schematic plan view of a second electrode.
FIGS. 7 to 55 are schematic views of each process operation for describing a method of manufacturing a display device.
FIG. 56 is a schematic block diagram illustrating an electronic device 1000 including a display device.
FIG. 57 is a schematic diagram illustrating an example where the electronic device 1000 of FIG. 56 is a smartphone.
FIG. 58 is a schematic diagram illustrating an example where the electronic device 1000 of FIG. 56 is a tablet computer.

### DETAILED DESCRIPTION

Since the present disclosure can apply various transformations and have various embodiments, specific embodiments will be illustrated in the drawings and described in detail in the detailed description. However, it should be understood that this is not intended to limit the present disclosure to a specific disclosed form, and includes all modifications, equivalents, and substitutes included in the technical scope of the present disclosure.

The terms, "first," "second," and the like may be simply used for description of various constituent elements, but those meanings may not be limited to the restricted meanings. The above terms are used only for distinguishing one constituent element from other constituent elements. For example, a first constituent element may be referred to as a second constituent element and similarly, the second constituent element may be referred to as the first constituent element within the scope of the appended claims. An expression of a singular number includes an expression of the plural number, so long as it is clearly read differently.

In the specification, the word "comprise" or "has" is used to specify existence of a feature, numbers, a process, an operation, a constituent element, a part, or a combination thereof, and it will be understood that existence or additional possibility of one or more other features, numbers, processes, operations, constituent elements, parts, or combinations thereof are not excluded in advance. In addition, it will be understood that when an element such as a layer, film, area, or substrate is referred to as being "on" another element, it can be directly on the other element or intervening elements may also be present. In addition, in the specification, it will be understood that when an element such as a layer, film, region, or substrate is referred to as being located "on" another element, the arrangement direction is not limited to an upper direction and include a side direction or a lower direction. In contrast, it will be understood that when an element such as a layer, film, area, or substrate is referred to as being "beneath" another element, it can be directly beneath the other element or intervening elements may also be present.

Aspects of some embodiments of the present disclosure relate to a display device and a method of manufacturing the display device. Hereinafter, a display device and a method of manufacturing the display device according to an embodiment will be described with reference to the accompanying drawings.

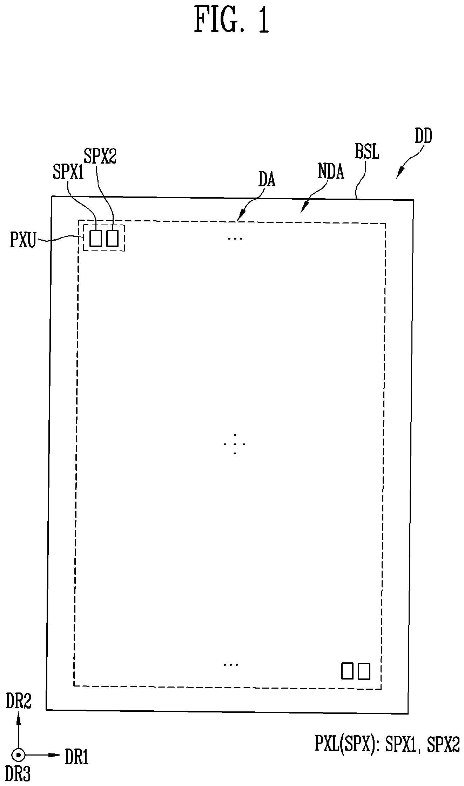

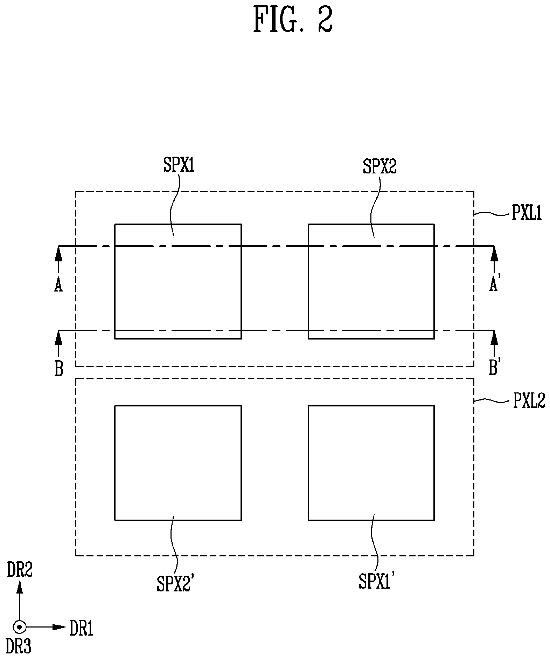

FIG. 1 is a schematic plan view of a display device. FIG. 2 is a schematic plan view of a pixel.

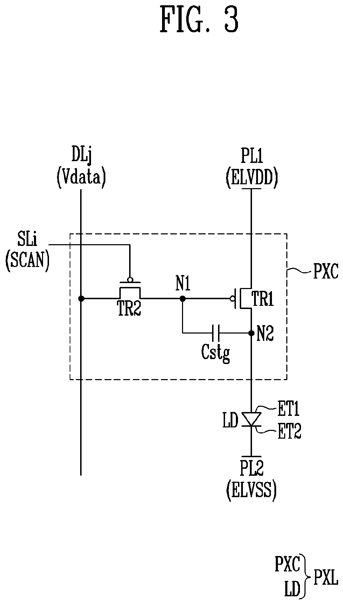

Referring to FIG. 1, a display device DD is configured to emit light. The display device DD includes light-emitting elements LD (see FIG. 3). The display device DD may be a device that displays a moving image or a still image. The display device DD may be used as a display screen of portable electronic devices such as a mobile phone, a smartphone, a tablet personal computer (PC), a smart watch, a watch phone, a mobile communication terminal, an electronic notebook, an electronic book, a portable multimedia player (PMP), a navigation system, and an ultra-mobile PC (UMPC) as well as various products such as a televisions, a laptop computer, a monitor, a billboard, and a device for the Internet of Things (IoT). However, the application field of the display device DD is not limited to specific examples.

The display device DD may be formed in a rectangular planar shape having a short side in a first direction DR1 and a long side in a second direction DR2 that intersects the first direction DR1. A corner at which the short side in the first direction DR1 and the long side in the second direction DR2 meet may be formed to be rounded to have a certain curvature or may be formed at a right angle. The planar shape of the display device DD is not limited to a quadrangular shape and may be formed in a round shape such as another polygonal, circular, oval shape, or irregular shape. Additionally, corners of the display device DD may be rounded or curved. The display device DD may be formed to be flat, but it is not limited thereto. For example, the display device DD may include a curved portion formed at each of left and right end and having a constant curvature or a variable curvature. In addition, the display device DD may be flexibly formed to be flexible, bendable, foldable, or rollable without damaging the display device DD. For example, the display device DD may be a flexible display device.

In the present disclosure, the first direction DR1 may be a "horizontal" direction that is a row direction of a pixel PXL. The second direction DR2 may be a column direction of the pixel PXL. The third direction DR3 may be a display direction of the display device DD or a normal direction of a plane on which a base layer BSL is located.

The base layer BSL may form a base surface of the display device DD. The base layer BSL may be a rigid or flexible substrate or film. For example, the base layer BSL may be a rigid substrate made of glass or tempered glass, a flexible substrate (or a thin film) made of plastic or metal, or at least one insulating layer. The material and/or physical properties of the base layer BSL are not particularly limited. The base layer BSL may be transparent (or substantially transparent). Here, the term "substantially transparent" may mean that light may be transmitted at a certain transmittance level or more. In other examples, the base layer BSL may be semi-transparent or opaque. In addition, the base layer BSL may include a reflective material.

The display device DD may include a display area DA and a non-display area NDA. The non-display area NDA may refer to an area other than the display area DA. The non-display area NDA may surround at least a portion of the display area DA.

The display area DA may refer to an area in which the pixel PXL is located. The non-display area NDA may refer to an area in which the pixel PXL is not located. A driving circuit unit, lines, and pads connected to the pixel PXL of the display area DA may be located in the non-display area NDA.

The pixel PXL (or subpixels SPX) may include a first subpixel SPX1 and a second subpixel SPX2. At least one first subpixel SPX1 and at least one second subpixel SPX2 may form one pixel unit PXU capable of emitting light with various colors. FIG. 1 illustrates that each pixel PXL includes two subpixels SPX1 and SPX2, that is, the first subpixel SPX1 and the second subpixel SPX2, it is not limited thereto.

The first subpixel SPX1 may emit at least one light of first light and second light, and the second subpixel SPX2 may emit at least one light of the first light and third light. For example, the first subpixel SPX1 may emit only the first light, only the second light, or light including the first light and the second light (for example, light including a light component of the first light and a light component of the second light. For example, the second subpixel SPX2 may emit only the first light, only the third light, or light including the first light and the third light (for example, light including a light component of the first light and a light component of the third light). Accordingly, the first and second subpixels SPX1 and SPX2 may form the pixel unit PXU, and the display device DD may form a pixel structure capable of displaying a full-color image.

The first light, the second light, and the third light may be light of different colors. Here, the first light may be light in a red wavelength band, the second light may be light in a green wavelength band, and the third light may be light in a blue wavelength band. The red wavelength band may be a wavelength band of 600 nanometers (nm) (or about 600 nm) to 750 nm (or about 750 nm), the green wavelength band may be a wavelength band of 480 nm (or about 480 nm) to 560 nm (or about 560 nm), and the blue wavelength band may be a wavelength band of 370 nm (or about 370 nm) to 460 nm (or about 460 nm), but it is not limited thereto. For example, the first light may be light in a blue wavelength band, the second light may be light in a green wavelength band, and the third light may be light in a red wavelength band. For example, the first light may be light in a blue wavelength band, the second light may be light in a red wavelength band, and the third light may be light in a green wavelength band.

The pixel PXL (or the subpixels SPX) may be arranged according to various arrangement structures, and are not particularly limited.

Referring to FIG. 2, a display device DD may include a first pixel PXL1 and a second pixel PXL2. Pixels PXL may include the first pixel PXL1 and the second pixel PXL2. The first pixel PXL1 and the second pixel PXL2 may be adjacent to each other in a second direction DR2.

The first pixel PXL1 may include a first subpixel SPX1 and a second subpixel SPX2. The first subpixel SPX1 and the second subpixel SPX2 may be arranged in a first direction DR1 (for example, a horizontal direction). However, the first subpixel SPX1 and the second subpixel SPX2 may be arranged in the second direction DR2 (for example, a column direction).

Hereinafter, for convenience of description, the description will be provided based on an example in which the first subpixel SPX1 and the second subpixel SPX2 are adjacent to each other in the first direction DR1.

The second pixel PXL2 may include a first subpixel SPX1' and a second subpixel SPX2'. The first subpixel SPX1' and the second subpixel SPX2' may be arranged in the first direction DR1 (for example, the horizontal direction). However, the first subpixel SPX1' and the second subpixel SPX2' may be arranged in the second direction DR2 (for example, the column direction).

Hereinafter, for convenience of description, the description will be based on examples in which the first subpixel SPX1' and the second subpixel SPX2' are adjacent to each other in the first direction DR1.

The first subpixel SPX1 of the first pixel PXL1 and the first subpixel SPX1' of the second pixel PXL2 may be arranged in a diagonal direction. The second subpixel SPX2 of the first pixel PXL1 and the second subpixel SPX2' of the second pixel PXL2 may be arranged in a diagonal direction.

In the present specification, the diagonal direction may be a direction extending between the first direction DR1 and the second direction DR2.

Accordingly, the subpixels SPX1, SPX1', SPX2, and SPX2' of the first and second pixels PXL1 and PXL2 may be arranged in various arrangement structures. For example, the subpixels SPX1, SPX1', SPX2, and SPX2' of the first and second pixels PXL1 and PXL2 may be arranged in a hexagonal, rectangular, or square arrangement structure.

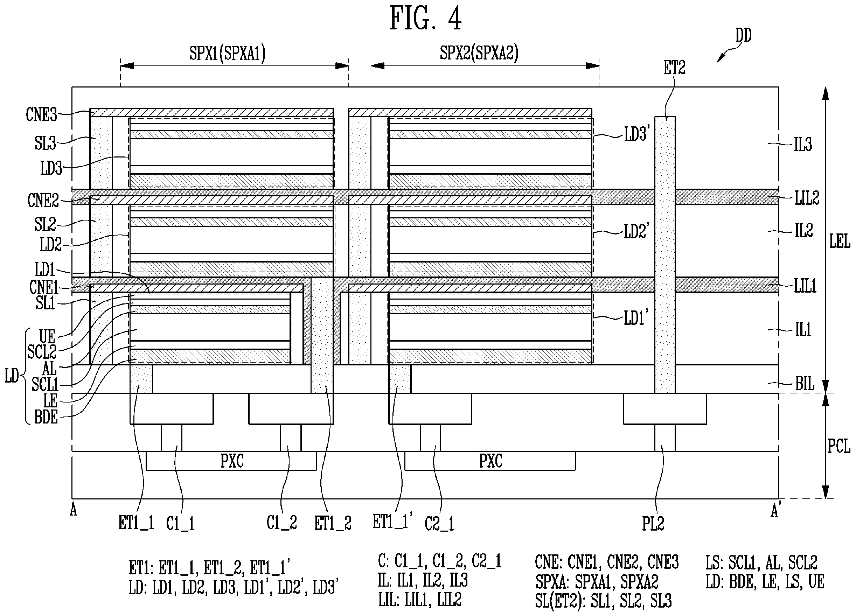

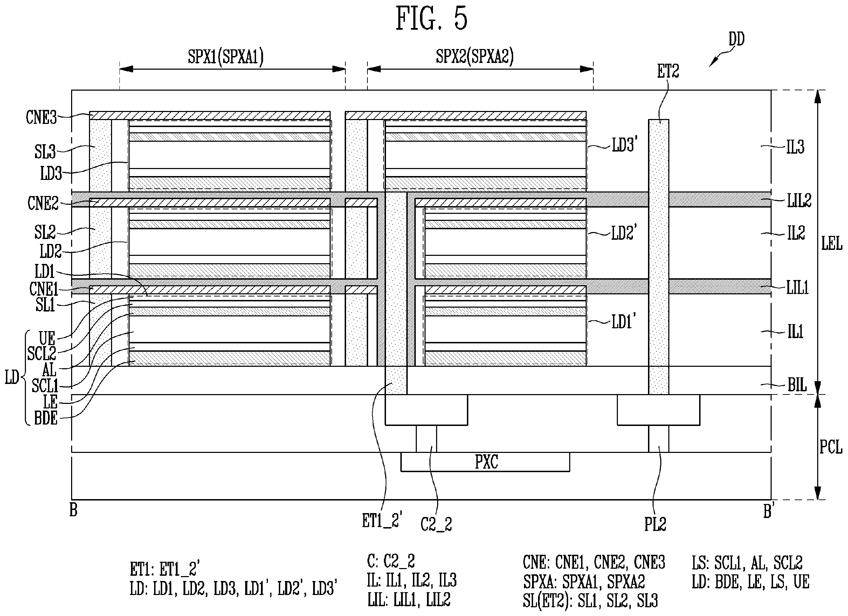

Each of the first subpixel SPX1 and the second subpixel SPX2 may include an inorganic light-emitting element including an inorganic semiconductor as a light-emitting element that emits light. For example, each of the first subpixel SPX1 and the second subpixel SPX2 may include a light-emitting element LD shown in FIGS. 4 and 5 as an inorganic light-emitting element.

FIG. 3 is an equivalent circuit diagram of a pixel. Although FIG. 3 illustrates various components in a pixel circuit, the components are not limited thereto, and the pixel circuit may include additional components.

FIG. 3 illustrates an electrical connection relationship of components included in a pixel PXL that may be applied to an active display device. However, types of the components included in the pixel PXL are not necessarily limited thereto. The pixel PXL shown in FIG. 3 may be one of the first subpixel SPX1 and the second subpixel SPX2 included in the display device DD of FIG. 1.

Referring to FIG. 3, each pixel PXL may include a light-emitting element LD that generates light with luminance corresponding to a data signal. The pixel PXL may include a pixel circuit PXC configured to drive the light-emitting element LD.

The pixel PXL may include at least one light-emitting element LD electrically connected between a first power line PL1 to which a first power voltage ELVDD is applied and a second power line PL2 to which a second power voltage ELVSS is applied. For example, the light-emitting element LD may include a first electrode ET1 connected (for example, electrically connected) to the pixel circuit PXC and the first power line PL1, and a second electrode ET2 connected (for example, electrically connected) to the second power line PL2. The first electrode ET1 may be an anode, and the second electrode ET2 may be a cathode. The light-emitting element LD may further include a light-emitting structure LS (see FIG. 4) that emits light by receiving a voltage through the first electrode ET1 and the second electrode ET2. The light-emitting structure LS will be described in more detail later through the drawings in FIG. 4 and below.

The first power voltage ELVDD and the second power voltage ELVSS may have different potentials. In this case, a potential difference between the first power voltage ELVDD and the second power voltage ELVSS may be set to be greater than or equal to a threshold voltage of the light-emitting element LD during an emission period of the pixel PXL.

The light-emitting element LD may function as a light source of the pixel PXL. The light-emitting element LD may emit light with luminance corresponding to a driving current supplied through the pixel circuit PXC. For example, during each frame period, the pixel circuit PXC may supply a driving current corresponding to a grayscale value of corresponding frame data. Accordingly, the light-emitting element LD may emit light with luminance corresponding to the driving current.

The pixel circuit PXC may be connected (for example, electrically connected) to a scan line SLi and a data line DLj of the pixel PXL. As an example, when the pixel PXL is placed in an i^{th} row and a j^{th} column of a display area DA (see FIG. 1), wherein i and j are each an integer that is greater than or equal to 1, the pixel circuit PXC of the pixel PXL may be connected to an i^{th} scan line SLi and a j^{th} data line DLj of the display area DA. The pixel circuit PXC may include first and second transistors TR1 and TR2 and a storage capacitor Cst. However, the structure of the pixel circuit PXC is not limited to that shown in FIG. 3.

The first transistor TR1 may include a gate electrode connected (for example, electrically connected) to a first node N1. The first transistor TR1 may include a first electrode connected (for example, electrically connected) to a second node N2. The first transistor TR1 may include a second electrode connected (for example, electrically connected) to the first power line PL1. The first electrode may be any one (for example, a drain electrode) of a source electrode and the drain electrode. The second electrode may be the other (for example, the source electrode) of the source electrode and the drain electrode. A current (for example, a driving current) corresponding to a voltage applied to the first node N1 may flow in the first transistor TR1. The first transistor TR1 may be referred to as a driving transistor.

The second transistor TR2 may be configured to write a data voltage Vdata to the pixel circuit PXC. The second transistor TR2 may include a gate electrode connected (for example, electrically connected) to the i^{th} scan line SLi. In response to a scan signal SCAN (for example, a scan signal SCAN having a turn-on level) input to the i^{th} scan line SLi, the second transistor TR2 may be configured to input the data voltage Vdata to the pixel circuit PXC. The second transistor TR2 may be configured to switch an electrical connection between the j^{th} data line DLj and the first node N1. The second transistor TR2 may be referred to as a switching transistor.

The storage capacitor Cstg may include one electrode connected (for example, electrically connected) to the first node N1 and the other electrode connected (for example, electrically connected) to the second node N2. The storage capacitor Cstg may be configured to maintain a voltage difference between the first node N1 and the second node N2. For example, the storage capacitor Cstg may be configured to maintain the data voltage Vdata applied to the first node N1 during a certain period (for example, one frame period).

FIG. 3 illustrates the pixel circuit PXC including the second transistor TR2 configured to write the data voltage Vdata to the pixel PXL, the storage capacitor Cstg for storing the data voltage, and the first transistor TR) configured to supply a driving current corresponding to the data voltage Vdata to the light-emitting element LD. However, the structure of the pixel circuit PXC may be modified in various ways. As an example, the pixel circuit PXC may include a transistor element configured to compensate for a change in threshold voltage of the first transistor TR1, a transistor element configured to initialize a voltage of the first node N1, and/or a transistor element configured to control a length of time during which the light-emitting element (LD) (or light-emitting elements) emits light. The pixel circuit PXC may further include circuit elements such as a boosting capacitor for boosting a voltage of the first node N1.

FIG. 3 illustrates that the pixel circuit PXC includes the first and second transistors TR1 and TR2, each of which includes a p-type semiconductor layer (for example, is implemented as a P-channel metal oxide semiconductor (PMOS)). However, they are not limited thereto, and at least one of the first or second transistors TR1 or TR2 may be provided as a transistor including an n-type semiconductor layer (for example, an N-channel metal oxide semiconductor (NMOS)). For example, the p-type semiconductor layer may include a metal oxide semiconductor. For example, the n-type semiconductor layer may include a polycrystalline silicon semiconductor.

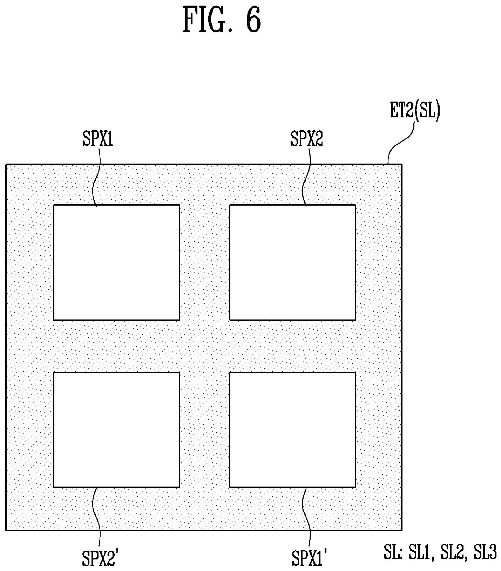

FIGS. 4 and 5 are schematic cross-sectional views of a display. FIG. 6 is a schematic plan view of a second electrode. FIG. 4 is a schematic cross-sectional view of a display device DD taken along the line A-A' of FIG. 2. FIG. 5 is a schematic cross-sectional view of the display device DD taken along the line B-B' of FIG. 2.

Referring to FIGS. 4 and 5, the display device DD may include subpixel areas SPXA in which subpixels SPX1 and SPX2 are located.

The subpixel areas SPXA may be areas formed by subpixels SPX and may be areas in which light with one color is provided.

The subpixel areas SPXA may include a first subpixel area SPXA1 formed by a first subpixel SPX1 and a second subpixel area SPXA2 formed by a second subpixel SPX2.

First color light, second color light, or a mixture of the first color light and the second color light may be provided in the first subpixel area SPXA1. The first color light, third color light, or a mixture of the first color light and the third color light may be provided in the second subpixel area SPXA2.

The display device DD may include a pixel circuit layer PCL and a display element layer LEL. The pixel circuit layer PCL and the display element layer LEL may be located on a base layer BS) (see FIG. 1) and may be arranged over the entire subpixel area SPXA.

The pixel circuit layer PCL may include a circuit unit C for driving light-emitting elements LD and a second power line PL2. For example, the pixel circuit layer PCL may include the circuit unit C for supplying an anode signal (for example, a signal supplied from a first power voltage ELVDD) to the light-emitting elements LD, and the second power line PL) for supplying a cathode signal (for example, a signal supplied from a second power voltage ELVSS).

The circuit unit C may correspond to at least one circuit of the pixel circuit PXC shown in FIG. 3. For example, the circuit unit C may be a part of the pixel circuit PXC. For example, the circuit unit C may be electrically connected to the pixel circuit PXC. The circuit unit C may include a 1-1 pixel circuit unit C1_1, a 1-2 pixel circuit unit C1_2, a 2-1 pixel circuit unit C2_1, and a 2-2 pixel circuit unit C2_2.

The 1-1 pixel circuit unit C1_1 and the 1-2 pixel circuit unit C1_2 may be located in the first subpixel area SPXA1. The 2-1 pixel circuit unit C2_1 and the 2-2 pixel circuit unit C2_2 may be located in the second subpixel area SPXA2. However, they are not limited thereto. The 1-1 pixel circuit unit C1_1 and the 1-2 pixel circuit unit C1_2 may be located inside and outside the first subpixel area SPXA1. The 2-1 pixel circuit unit C2_1 and the 2-2 pixel circuit unit C2_2 may be arranged over inside and outside the second subpixel area SPXA2.

The 1-1 pixel circuit unit C1_1 and the 1-2 pixel circuit unit C1_2 may be the pixel circuits PXC for driving the first subpixel SPX1 (or the light-emitting elements formed in the first subpixel SPX1). The 2-1 pixel circuit unit C2_1 and the 2-2 pixel circuit unit C2_2 maybe the pixel circuits PXC for driving the second subpixel SPX2 (or the light-emitting elements formed in the second subpixel SPX2).

The display element layer LEL may include the light-emitting elements LD, a first electrode ET1, and a second electrode ET2.

The light-emitting elements LD include a 1-1 light-emitting element LD1, a 1-2 light-emitting element LD2, and a 1-3 light-emitting element LD3, each located in the first subpixel area SPXA1, and may include a 2-1 light-emitting element LD1', a 2-2 light-emitting element LD2'), and a 2-3 light-emitting element LD3', each located in the second subpixel area SPXA2.

The 1-1 light-emitting element LD1 and the 2-1 light-emitting element LD1' may be located at the same layer. The 1-2 light-emitting element LD2 and the 2-2 light-emitting element LD2' may be located at the same layer. The 1-3 light-emitting element LD3 and the 2-3 light-emitting element LD3' may be located at the same layer.

The 1-1 light-emitting element LD1 and the 2-1 light-emitting element LD1' may be formed through the same process. For example, the 1-1 light-emitting element LD1 and the 2-1 light-emitting element LD1' may include the same material. The 1-2 light-emitting element LD2 and the 2-2 light-emitting element LD2' may be formed through the same process. For example, the 1-2 light-emitting element LD2 and the 2-2 light-emitting element LD2' may include the same material. The 1-3 light-emitting element LD3 and the 2-3 light-emitting element LD3' may be formed through the same process. For example, the 1-3 light-emitting element LD3 and the 2-3 light-emitting element LD3' may be formed through the same process.

The 1-1 light-emitting element LD1 may be located at the lowermost side among the 1-1 light-emitting element LD1, the 1-2 light-emitting element LD2, and the 1-3 light-emitting element LD3. The 2-1 light-emitting element LD1' may be located at the lowermost side among the 2-1 light-emitting element LD1', the 2-2 light-emitting element LD2', and the 2-3 light-emitting element LD3'.

The 1-2 light-emitting element LD2 may be located between the 1-1 light-emitting element LD1 and the 1-3 light-emitting element LD3. The 1-2 light-emitting element LD2 may be located on the 1-1 light-emitting element LD1. The 2-2 light-emitting element LD2' may be located between the 2-1 light-emitting element LD1' and the 2-3 light-emitting element LD3'. The 2-2 light-emitting element LD2' may be located on the 2-1 light-emitting element LD1'.

The 1-3 light-emitting element LD3 may be located at the uppermost side among the 1-1 light-emitting element LD1, the 1-2 light-emitting element LD2, and the 1-3 light-emitting element LD3. The 1-3 light-emitting element LD3 may be located on the 1-2 light-emitting element LD2. The 2-3 light-emitting element LD3' may be located at the uppermost side among the 2-1 light-emitting element LD1', the 2-2 light-emitting element LD2', and the 2-3 light-emitting element LD3'. The 2-3 light-emitting element LD3' may be located on the 2-2 light-emitting element LD2'.

Each of the light-emitting elements LD may include a bonding electrode BDE, a lower electrode LE, a light-emitting structure LS, and an upper electrode UE. The light-emitting structure LS may include a first semiconductor layer SCL1, an active layer AL, and a second semiconductor layer SCL2.

The bonding electrode BDE may include a eutectic metal. The bonding electrode BDE may include multiple layers. For example, the bonding electrode BDE may include multiple layers in which a first electrode layer including titanium (Ti), a second electrode layer including gold (Au) and/or tin (Sn), and a third electrode layer including titanium (Ti) are sequentially stacked. However, it is not limited thereto.

The lower electrode LE may be located on the bonding electrode BDE. When the light-emitting element LD is electrically connected to the circuit unit C, the lower electrode LE may receive an anode signal (for example, a signal supplied from the first power voltage ELVDD). However, it is not limited thereto. For example, when the second electrode ET2 is located below the light-emitting element LD so that a lower surface of the light-emitting element LD is electrically connected to the second electrode ET2, the lower electrode LE may receive a cathode signal (for example, a signal supplied from the second power voltage ELVSS).

The lower electrode LE may be implemented to be transparent (or substantially transparent) or semi-transparent to satisfy transmittance. The lower electrode LE may include at least one selected from conductive materials such as indium tin oxide (ITO), indium zinc oxide (IZO), zinc oxide (ZnOₓ), indium gallium zinc oxide. oxide (IGZO), and indium tin zinc oxide (ITZO). However, it is not limited thereto. The lower electrode LE may include a metal or a metal oxide. For example, the lower electrode LE may include at least one selected from copper (Cu), gold (Au), chromium (Cr), titanium (Ti), aluminum (Al), nickel (Ni), indium tin oxide (ITO), and an oxide or alloy thereof, but is not limited thereto.

The first semiconductor layer SCL1 may be located on the lower electrode LE. The first semiconductor layer SCL1 may include any one of a p-type semiconductor layer and an n-type semiconductor layer. Hereinafter, for convenience of description, examples in which the first semiconductor layer SCL1 includes the p-type semiconductor layer will be described as an example, but it is not limited thereto. The first semiconductor layer SCL1 may include a p-type semiconductor layer which includes a semiconductor material such as GaN, InGaN, InAlGaN, AlGaN, or AlN, magnesium (Mg), zinc (Zn), calcium (Ca), strontium (Sr), or barium (Ba) and is doped with a first conductive dopant (or a p-type dopant) such as magnesium (Mg), zinc (Zn), calcium (Ca), strontium (Sr), or barium (Ba).

The active layer AL may be located between the first semiconductor layer SCL1 and the second semiconductor layer SCL2. The active layer AL may include any one structure of a single well structure, a multi-well structure, a single quantum well structure, a multi quantum well (MQW) structure, a quantum dot structure, and a quantum wire structure, but is not limited thereto. The active layer AL may include AlGaN, InGaN, or GaN, and various other materials may constitute the active layer AL.

The active layers AL of the light-emitting elements LD located on different layers may be configured to emit pieces of light in different wavelength bands. For example, the 1-1 light-emitting element LD1, the 1-2 light-emitting element LD2, and the 1-3 light-emitting element LD3 may respectively have active layers configured to emit pieces of light in different wavelength bands. The 2-1 light-emitting element LD1', the 2-2 light-emitting element LD2', and the 2-3 light-emitting element LD3' may respectively have active layers configured to emit pieces of light in different wavelength bands.

For example, the active layer AL of the 1-1 light-emitting element LD1 and the 2-1 light-emitting element LD1' may be configured to emit light in a wavelength band corresponding to first light (for example, light in a red wavelength band), the active layer AL of the 1-2 light-emitting element LD2 and the 2-2 light-emitting element LD2' may be configured to emit light in a wavelength band corresponding to second light (for example, light in a green wavelength band), and the active layer AL of the 1-3 light-emitting element LD3 and the 2-3 light-emitting element LD3' may be configured to emit light in a wavelength band corresponding to third light (for example, light in a blue wavelength band). However, they are not limited thereto.

The second semiconductor layer SCL2 may be positioned on the active layer AL. The second semiconductor layer SCL2 may include the other of the p-type semiconductor layer and the n-type semiconductor layer. Hereinafter, for convenience of description, examples in which the second semiconductor layer SCL2 includes the n-type semiconductor layer will be described as an example, but they are not limited thereto. The second semiconductor layer SCL2 may be an n-type semiconductor layer which includes a semiconductor material such as GaN, InGaN, InAlGaN, AlGaN, or AlN and is doped with a second conductive dopant (or an n-type dopant) such as germanium (Ge), selenium (Se), tellurium (Te), or tin (Sn). As an example, the second semiconductor layer SCL2 may include a GaN semiconductor material doped with the second conductive dopant (or the n-type dopant). However, a material constituting the second semiconductor layer SCL2 is not limited thereto, and the second semiconductor layer SCL2 may be made of various other materials.

The upper electrode UE may be located on the second semiconductor layer SCL2. When the light-emitting element LD is electrically connected to the second electrode ET2, the upper electrode UE may receive a cathode signal. However, it is not limited thereto. For example, when the light-emitting element LD is electrically connected to the first electrode ET1, the upper electrode UE may receive an anode signal.

The upper electrode UE may be implemented to be transparent (or substantially transparent) or semi-transparent to satisfy certain transmittance. The upper electrode UE may include at least one selected from conductive materials such as indium tin oxide (ITO), indium zinc oxide (IZO), zinc oxide (ZnOₓ), indium gallium zinc oxide. oxide (IGZO), or indium tin zinc oxide (ITZO). However, it is not limited thereto. The upper electrode UE may include a metal or a metal oxide. For example, the upper electrode UE may include at least one selected from copper (Cu), gold (Au), chromium (Cr), titanium (Ti), aluminum (Al), nickel (Ni), indium tin oxide (ITO), and an oxide or alloy thereof, but is not limited thereto.

The first electrode ET1 may include a 1-1 electrode ET1_1, a 1-2 electrode ET1_2, a 2-1 electrode ET1_1', and a 2-2 electrode ET1_2'. The 1-1 electrode ET1_1 and the 1-2 electrode ET1_2 may be located in the first subpixel area SPXA1. The 2-1 electrode ET1_1' and the 2-2 electrode ET1_2' may be located in the second subpixel area SPXA2.

The 1-1 electrode ET1_1 may be connected to the 1-1 pixel circuit unit C1_1. For example, the 1-1 electrode ET1_1 may be electrically connected to the 1-1 pixel circuit unit C1_1. The 1-1 electrode ET1_1 may electrically connect the 1-1 pixel circuit unit C1_1 and the 1-1 light-emitting element LD1.

The 1-2 electrode ET1_2 may be connected to the 1-2 pixel circuit unit C1_2. For example, the 1-2 electrode ET1_2 may be electrically connected to the 1-2 pixel circuit unit C1_2. The 1-2 electrode ET1_2 may electrically connect the 1-2 pixel circuit unit C1_2 and the 1-2 light-emitting element LD2.

The 2-1 electrode ET1_1' may be connected to the 2-1 pixel circuit unit C2_1. For example, the 2-1 electrode ET1_1' may be electrically connected to the 2-1 pixel circuit unit C2_1. The 2-1 electrode ET1_1' may electrically connect the 2-1 pixel circuit unit C2_1 and the 2-1 light-emitting element LD1'.

The 2-2 electrode ET1_2' may be connected to the 2-2 pixel circuit unit C2_2. For example, the 2-2 electrode ET1_2' may be electrically connected to the 2-2 pixel circuit unit C2_2. The 2-2 electrode ET1_2' may electrically connect the 2-2 pixel circuit unit C2_2 and the 2-3 light-emitting element LD3'.

At least a portion of the first electrode ET1 may not overlap at least some of the light-emitting elements LD in a plan view (for example, in a third direction DR3). For example, the 1-2 electrode ET1_2 may not overlap the 1-1 light-emitting element LD1 in a plan view. The 2-2 electrode ET1_2' may not overlap the 2-1 light-emitting element LD1' and the 2-2 light-emitting element LD2' in a plan view.

The second electrode ET2 may be connected to the second power line PL2. For example, the second electrode ET2 may be electrically connected to the second power line PL2. Accordingly, the second electrode ET2 may function as a common electrode of the first and second subpixels SPX1 and SPX2.

The second electrode ET2 may not overlap the light-emitting element LD in a plan view. The second electrode ET2 may be located outside the subpixel area SPXA. However, it is not limited thereto. For example, the second electrode ET2 may overlap at least a portion of the light-emitting element LD in a plan view.

The second electrode ET2 may have a mesh structure in a plan view. This will be described below with reference to FIG. 6.

Positions of the first electrode ET1 and the second electrode ET2 may be changed. For example, the second electrode ET2 located outside the subpixel area SPXA may be changed into the first electrode ET1, and in this case, the second power line PL2 may be changed into the first power line PL1. Hereinafter, descriptions will be provided based on examples in which the first electrode ET1 and the second electrode ET2 are located at positions shown in FIGS. 4 and 5.

The display device DD may further include a base insulating layer BIL, an insulating layer IL, an interlayer insulating layer LIL, a conductive layer SL, and a connection electrode CNE.

The base insulating layer BIL may be located on the pixel circuit layer PCL. At least a portion of the base insulating layer BIL may be located between the pixel circuit layer PCL and the 1-1 light-emitting element LD1 and between the pixel circuit layer PCL and the 2-1 light-emitting element LD1'.

At least a portion of the base insulating layer BIL may include an opening passing through the base insulating layer BIL. The above-described first electrode ET1 may pass through the opening of the base insulating layer BIL. For example, the 1-1 electrode ET1_1, the 1-2 electrode ET1_2, the 2-1 electrode ET1_1', and the 2-2 electrode ET1_2' may pass through the base insulating layer BIL.

The base insulating layer BIL may include an inorganic material such as silicon oxide (SiOₓ), silicon nitride (SiNₓ), silicon oxynitride (SiOₓN_{y}), silicon oxycarbide (SiOₓC_{y}), aluminum oxide (AlOₓ), aluminum nitride (AlNₓ), zirconium oxide (ZrOₓ), hafnium oxide (HfOₓ), or titanium oxide (TiOₓ).

The insulating layer IL may be located on the base insulating layer BIL. The insulating layer IL may be located at the same layer as each of the light-emitting elements LD. The insulating layer IL may surround the light-emitting elements LD.

The insulating layer IL may include an inorganic material such as silicon oxide (SiOₓ), silicon nitride (SiNₓ), silicon oxynitride (SiOₓN_{y}), silicon oxycarbide (SiOₓC_{y}), aluminum oxide (AlOₓ), aluminum nitride (AlNₓ), zirconium oxide (ZrOₓ), hafnium oxide (HfOₓ), or titanium oxide (TiOₓ).

The insulating layer IL may include a first insulating layer IL1, a second insulating layer IL2, and a third insulating layer IL3.

The first insulating layer IL1 may be located on the base insulating layer BIL. The first insulating layer IL1 may be located at the same layer as the 1-1 light-emitting element LD1 and the 2-1 light-emitting element LD1'. The first insulating layer IL1 may surround the 1-1 light-emitting element LD1 and the 2-1 light-emitting element LD1'.

The second insulating layer IL2 may be located on the first insulating layer IL1. The second insulating layer IL2 may be located at the same layer as the 1-2 light-emitting element LD2 and the 2-2 light-emitting element LD2'. The second insulating layer IL2 may surround the 1-2 light-emitting element LD2 and the 2-2 light-emitting element LD2'.

The third insulating layer IL3 may be located on the second insulating layer IL2. The third insulating layer IL3 may be located at the same layer as the 1-3 light-emitting element LD3 and the 2-3 light-emitting element LD3'. The third insulating layer IL3 may surround the 1-3 light-emitting element LD3 and the 2-3 light-emitting element LD3'.

The interlayer insulating layer LIL may be located on one insulating layer IL. The interlayer insulating layer LIL may be located between the light-emitting elements LD located on and below the interlayer insulating layer LIL to electrically insulate the light-emitting elements LD located in the same subpixel area SPXA from each other. The interlayer insulating layer LIL may expose a lower surface of at least a portion of the light-emitting elements LD.

The interlayer insulating layer LIL may include an inorganic material such as silicon oxide (SiOₓ), silicon nitride (SiNₓ), silicon oxynitride (SiOₓN_{y}), silicon oxycarbide (SiOₓC_{y}), aluminum oxide (AlOₓ), aluminum nitride (AlNₓ), zirconium oxide (ZrOₓ), hafnium oxide (HfOₓ), or titanium oxide (TiOₓ).

The interlayer insulating layer LIL may include a first interlayer insulating layer LIL1 and a second interlayer insulating layer LIL2.

The first interlayer insulating layer LIL1 may be located on the first insulating layer IL1. At least a portion of the first interlayer insulating layer LIL1 may be located between the 1-1 light-emitting element LD1 and the 1-2 light-emitting element LD2 and between the 2-1 light-emitting element LD1' and the 2-2 light-emitting element. LD2'. The first interlayer insulating layer LIL1 may be located between the first insulating layer IL1 and the second insulating layer IL2.

The first interlayer insulating layer LIL1 may expose a lower surface of the 1-2 light-emitting element LD2. For example, at least a portion of the 1-2 light-emitting element LD2 (or the exposed lower surface of the 1-2 light-emitting element LD2) may not overlap the first interlayer insulating layer LIL1 in a plan view. Hereinafter, in the present disclosure, a downward direction is defined as a direction opposite to the third direction DR3.

The first interlayer insulating layer LIL1 may expose the lower surface of the 1-2 light-emitting element LD2, and an exposed lower surface of the first interlayer insulating layer LIL1 may function as a contact portion through which the 1-2 light-emitting element LD2 and the 1-2 electrode ET1_2 may be electrically connected. For example, the 1-2 electrode ET1_2 may be electrically connected to the 1_2 pixel circuit unit C1_2, and the 1-2 electrode ET1_2 may be electrically connected to the 1-2 light-emitting element LD2 by passing through the first insulating layer IL1 and the first interlayer insulating layer LIL1.

The second interlayer insulating layer LIL2 may be located on the second insulating layer IL2. At least a portion of the second interlayer insulating layer LIL2 may be located between the 1-2 light-emitting element LD2 and the 1-3 light-emitting element LD3 and between the 2-2 light-emitting element (D2' and the 2-3 light-emitting element. LD3'. The second interlayer insulating layer LIL2 may be located between the second insulating layer IL2 and the third insulating layer IL3.

The second interlayer insulating layer LIL2 may expose a lower surface of the 2-3 light-emitting element LD3'. For example, at least a portion of the 2-3 light-emitting element LD3' (or the exposed lower surface of the 2-3 light-emitting element LD3') may not overlap the second interlayer insulating layer LIL2 in a plan view. The second interlayer insulating layer LIL2 may expose the lower surface of the 2-3 light-emitting element LD3', and an exposed lower surface of the second interlayer insulating layer LIL2 may function as a contact portion through which the 2-3 light-emitting element LD3' and the 2-2 electrode ET1_2' may be electrically connected. For example, the 2-2 electrode ET1_2' may be electrically connected to the 2_2 pixel circuit unit C2_2, and the 2-2 electrode ET1_2' may be electrically connected to the 2-3 light-emitting element LD3' by passing through the first and second insulating layers IL1 and IL2 and the first and second interlayer insulating layers LIL1 and LIL2.

The second interlayer insulating layer L1L2 may not expose a lower surface of the first-third light-emitting element LD3. For example, the lower surface of the first-third light-emitting element LD3 may be completely in contact with the second interlayer insulating layer L1L2. Accordingly, among the 1-1 light-emitting element LD1, the 1-2 light-emitting element LD2, and the 1-3 light-emitting element LD3 located in the first subpixel area SPXA1, the 1-1 light-emitting element LD1 and the 1-2 light-emitting element LD2 may be electrically connected to the pixel circuit PXC, and the 1-3 light-emitting element LD3 may not be electrically connected to the pixel circuit PXC. For example, the 1-1 light-emitting element LD1 may be electrically connected to the 1-1 electrode ET1-1 of the pixel circuit PXC, and the 1-2 light-emitting element LD2 may be electrically connected to the 1-1 electrode ET1-1 of the pixel circuit PXC, and the 1-3 light-emitting element LD3 may not be electrically connected to the first electrode ET1 of the pixel circuit PXC.

The first interlayer insulating layer L1L1 may not expose the lower surface of the 2-2 light-emitting element LD2'. For example, the lower surface of the 2-2 light-emitting element LD2' may be completely in contact with the first interlayer insulating layer L1L1. Accordingly, among the 2-1 light-emitting element LD1', the 2-2 light-emitting element LD2', and the 2-3 light-emitting element LD3' located in the second subpixel area SPXA2, the 2-1 and 2-3 light-emitting elements LD1' and LD3' may be electrically connected to the pixel circuit PXC, and the 2-2 light-emitting element LD2' may not be electrically connected to the pixel circuit PXC. For example, the 2-1 light-emitting element LD1' may be electrically connected to the 2-1 electrode ET1-1' of the pixel circuit PXC, the 2-3 light-emitting element LD3' may be connected to the 2-2 electrode ET1-2' of the pixel circuit PXC, and the 2-2 light-emitting element LD2' may not be electrically connected to the first electrode ET1 of the pixel circuit PXC.

In other words, the 1-1 and 1-2 light-emitting elements LD1 and LD2 located in the first subpixel area SPXA1 may be electrically connected to the pixel circuit PXC, and the 1-3 light-emitting elements LD3 may not be electrically connected to the pixel circuit PXC. The 2-1 and 2-3 light-emitting elements LD1' and LD3' located in the second subpixel area SPXA2 may be electrically connected to the pixel circuit PXC, and the 2-2 light-emitting element LD2' may not be electrically connected to the pixel circuit PXC.

Accordingly, light efficiency can be increased in the high-resolution display device DD. When all of the 1-1 light-emitting element LD1, the 1-2 light-emitting element LD2, and the 1-3 light-emitting element LD3 are electrically connected to the pixel circuit PXC in one subpixel area (for example, the first subpixel area SPXA1), there may be a risk of light efficiency being reduced. For example, in a structure in which the 1-1 light-emitting element LD1, the 1-2 light-emitting element LD2, and the 1-3 light-emitting element LD3 are vertically stacked, when all of the 1-1 light-emitting element LD1, the 1-2 light-emitting element LD2, and the 1-3 light-emitting element LD3 are electrically connected to the pixel circuit PXC, an additional 1-3 electrode is required to electrically connect the 1-3 light-emitting element LD3 to the pixel circuit PXC. In this case, when the 1-3 electrode is formed, at least a portion of the 1-1 and 1-2 light-emitting elements LD1 and LD2 may be etched, thereby reducing light efficiency.

In the display device DD according to the present disclosure, only two of the light-emitting elements LD are electrically connected to the pixel circuit PXC in one subpixel area SPXA, thereby reducing the number of electrodes. Accordingly, light efficiency can be increased by reducing the need for some of the light-emitting elements LD to be further etched.

The connection electrode CNE may be located on each of the light-emitting elements LD. The connection electrode CNE may be in contact with an upper surface of each of the light-emitting elements LD.

The connection electrode CNE may be implemented to be transparent (or substantially transparent) or semi-transparent to satisfy certain transmittance. The connection electrode CNE may include at least one selected from conductive materials such as indium tin oxide (ITO), indium zinc oxide (IZO), zinc oxide (ZnOₓ), indium gallium zinc oxide (IGZO), or indium tin zinc oxide (ITZO).

The connection electrode CNE may be electrically connected to the second electrode ET2 and the conductive layer SL and may supply a cathode signal (for example, the second power voltage ELVSS) to the light-emitting elements LD. The connection electrode CNE may include a first connection electrode CNE1, a second connection electrode CNE2, and a third connection electrode CNE3.

The first connection electrode CNE1 may be located on the 1-1 light-emitting element LD1 and the 2-1 light-emitting element LD1'. The first connection electrode CNE1 may be in contact with upper surfaces of the 1-1 light-emitting element LD1 and the 2-1 light-emitting element LD1' (or may cover the supper surfaces). The first connection electrode CNE1 may supply a cathode signal to the 1-1 light-emitting element LD1 and the 2-1 light-emitting element LD1'.

The second connection electrode CNE2 may be located on the 1-2 light-emitting element LD2 and the 2-2 light-emitting element LD2'. The second connection electrode CNE2 may be in contact with upper surfaces of the 1-2 light-emitting element LD2 and the 2-2 light-emitting element LD2' (or may cover the upper surfaces). The second connection electrode CNE2 may supply a cathode signal to the 1-2 light-emitting element LD2 and the 2-2 light-emitting element LD2'.

The third connection electrode CNE3 may be located on the 1-3 light-emitting element LD3 and the 2-3 light-emitting element LD3'. The third connection electrode CNE3 may be in contact with upper surfaces of the 1-3 light-emitting elements LD3 and 2-3 light-emitting elements LD3' (or may cover the upper surfaces). The third connection electrode CNE3 may supply a cathode signal to the 1-3 light-emitting element LD3 and the 2-3 light-emitting element LD3'.

The conductive layer SL may be located below the connection electrode CNE. The conductive layer SL may include a first conductive layer SL1, a second conductive layer SL2, and a third conductive layer SL3.

Referring to FIG. 6, the conductive layer SL may be connected (or electrically connected) to the second electrode ET2. The conductive layer SL (each of the first conductive layer SL1, the second conductive layer SL2, and the third conductive layer SL3) may be integrally connected to the second electrode ET2.

The conductive layer SL (each of the first conductive layer SL1, the second conductive layer SL2, and the third conductive layer SL3) and the second electrode ET2 may be located in areas outside areas in which the light-emitting elements are located in a plan view. For example, the first conductive layer SL1 and the second electrode ET2 may be located in areas outside areas in which the 1-1 light-emitting element LD1 and the 2-1 light-emitting element LD1' are located. For example, the areas in which the first conductive layer SL1 and the second electrode ET2 located may not overlap the areas in which the 1-1 light-emitting element LD1 and the 2-1 light-emitting element LD1) are located in a plan view.

The conductive layer SL (each of the first conductive layer SL1, the second conductive layer SL2, and the third conductive layer SL3) and the second electrode ET2 may be arranged to surround the light-emitting elements LD in a plan view. For example, the conductive layer SL (each of the first conductive layer SL1, the second conductive layer SL2, and the third conductive layer SL3) and the second electrode ET2 may be integrally connected to each other to have a mesh structure in a plan view.

Each of the first conductive layer SL1, the second conductive layer SL2, and the third conductive layer SL3 may be formed through the same process as at least a portion of the second electrode ET2. Each of the first conductive layer SL1, the second conductive layer SL2, and the third conductive layer SL3 may include the same material as at least a portion of the second electrode ET2.

The conductive layer SL may include a conductive metal. For example, the conductive layer SL may include copper (Cu). However, it is not limited thereto. Accordingly, the conductive layer SL may receive a cathode signal from the second electrode ET2 and may supply the received cathode signal to each of the light-emitting elements LD.

The first conductive layer SL1 may be located below the first connection electrode CNE1. The first conductive layer SL1 may be in contact with the first connection electrode CNE1. The first conductive layer SL1 may be connected (or electrically connected) to the second electrode ET2 and may supply a cathode signal to the 1-1 light-emitting element LD1 and the 2-1 light-emitting element LD1'.

The second conductive layer SL2 may be located below the second connection electrode CNE2. The second conductive layer SL2 may be in contact with the second connection electrode CNE2. The second conductive layer SL2 may be connected (or electrically connected) to the second electrode ET2 and may supply a cathode signal to the 1-2 light-emitting element LD2 and the 2-2 light-emitting element LD2'.

The third conductive layer SL3 may be located below the third connection electrode CNE3. The third conductive layer SL3 may be in contact with the third connection electrode CNE3. The third conductive layer SL3 may be connected (or electrically connected) to the second electrode ET2 and may supply a cathode signal to the 1-3 light-emitting element LD3 and the 2-3 light-emitting element LD3'.

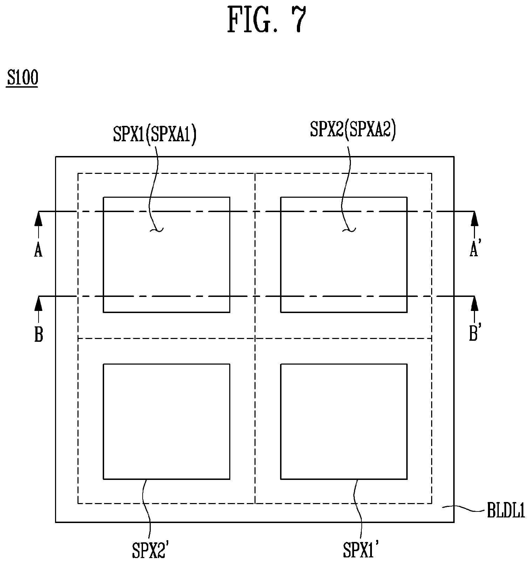

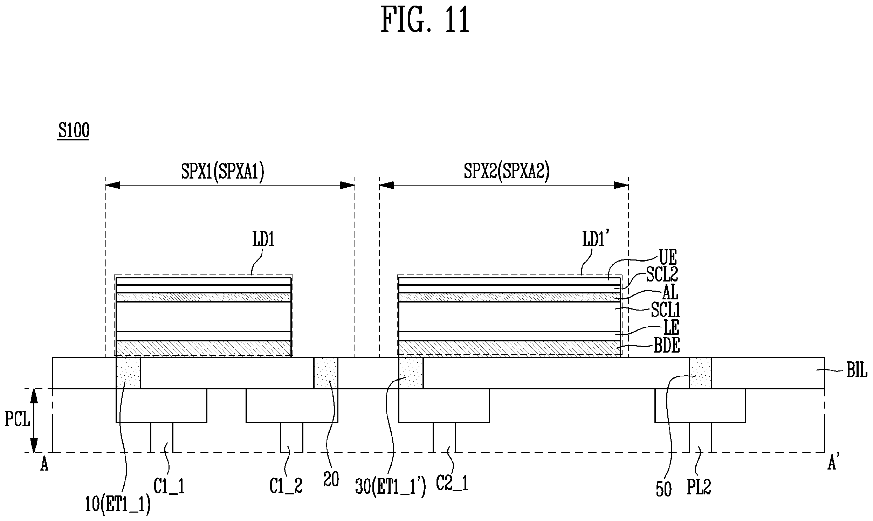

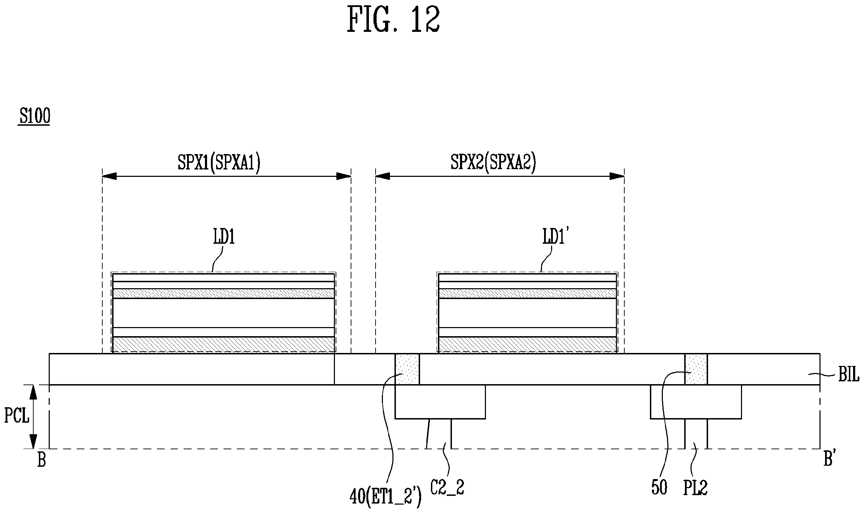

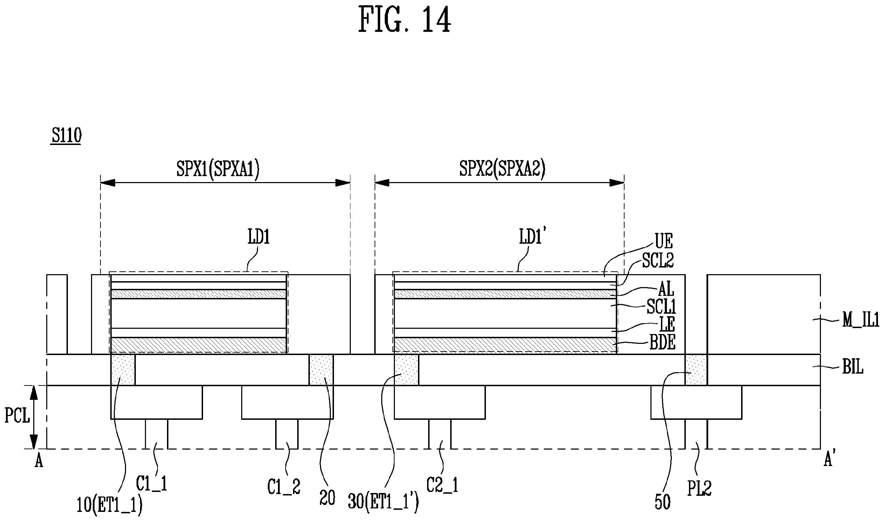

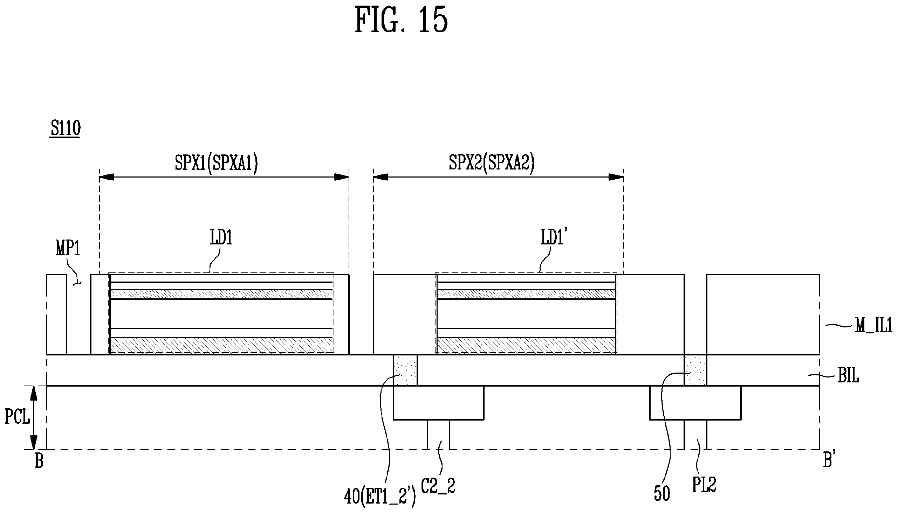

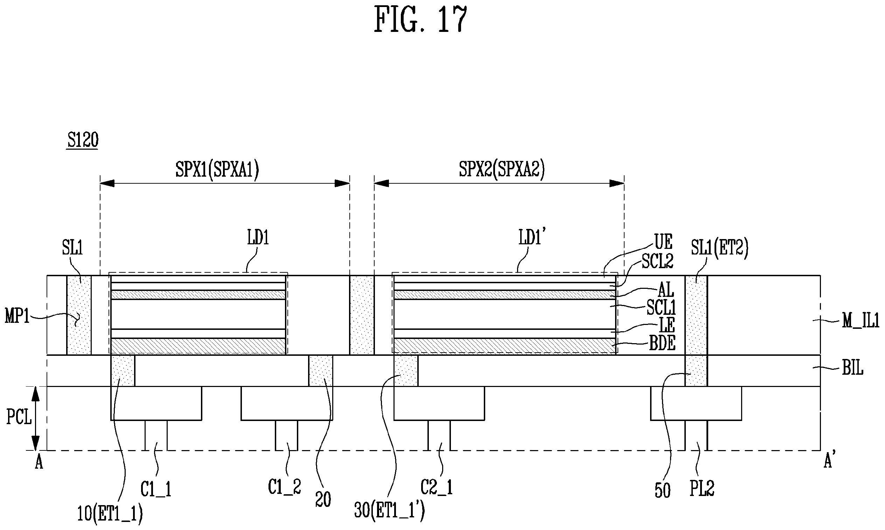

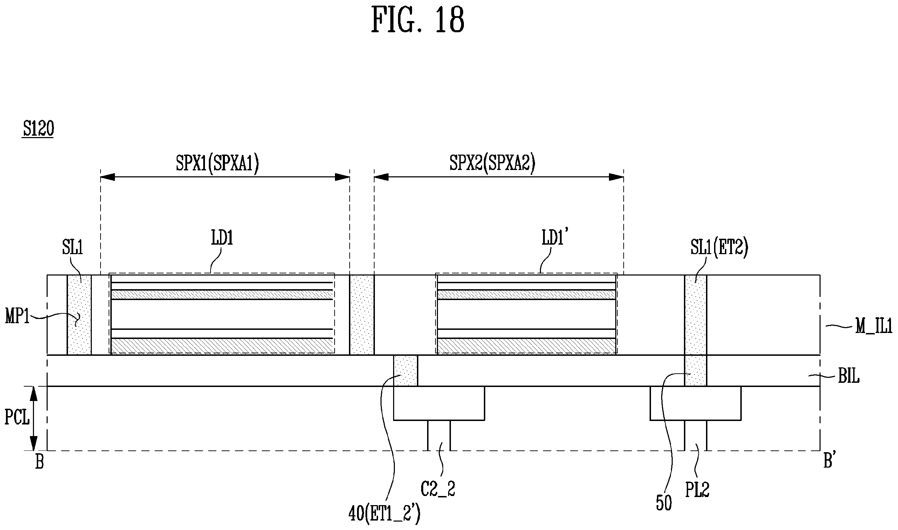

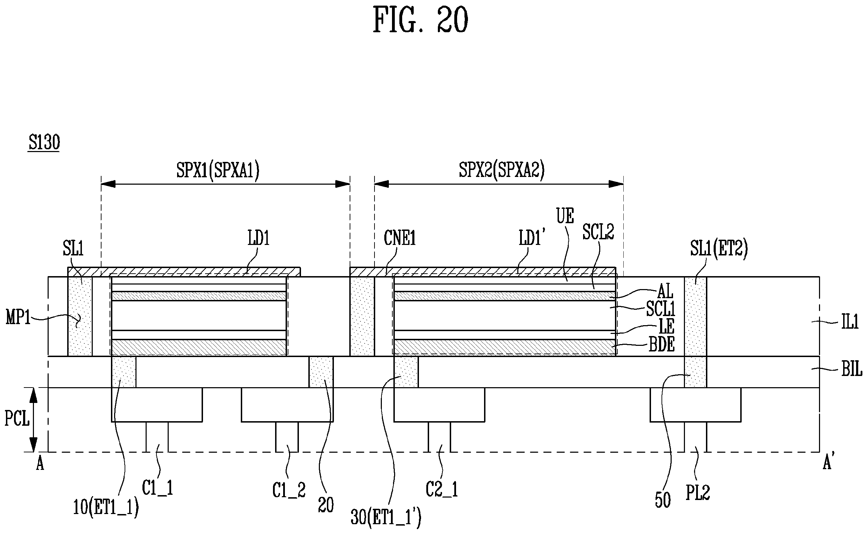

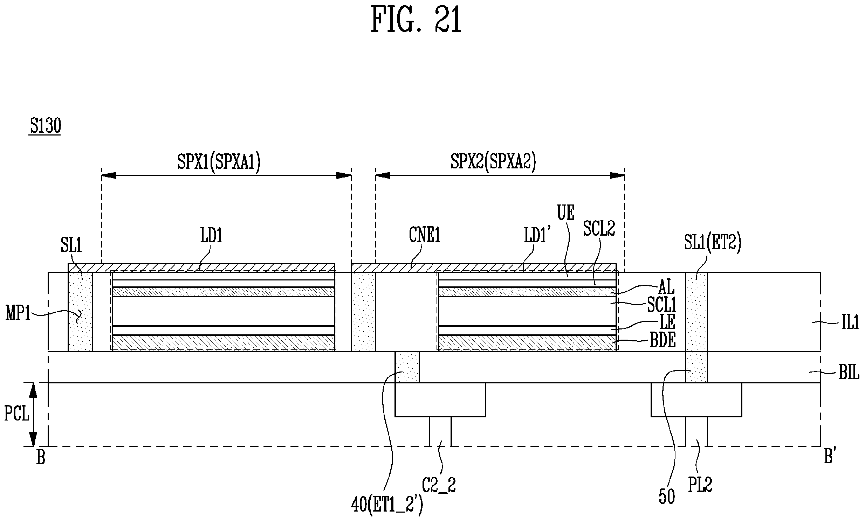

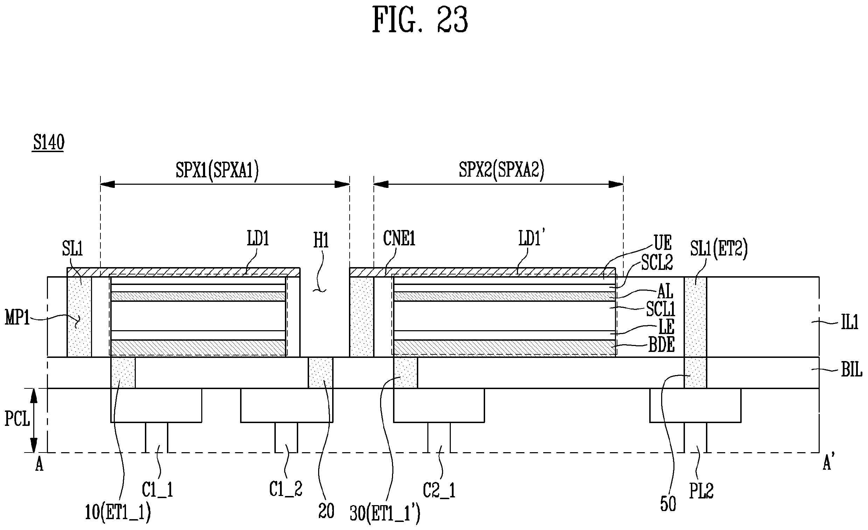

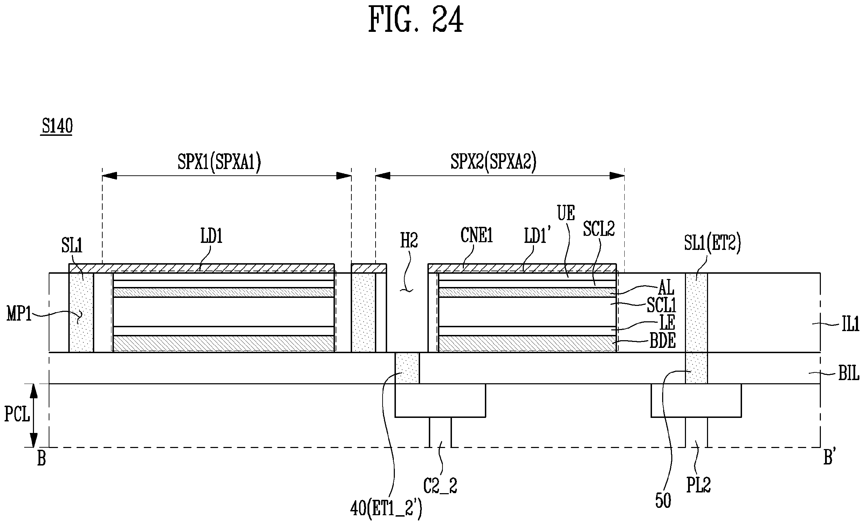

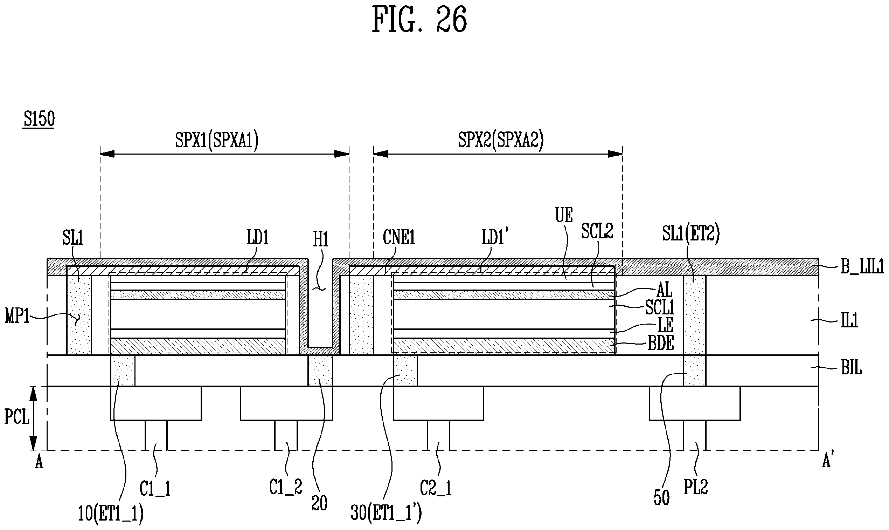

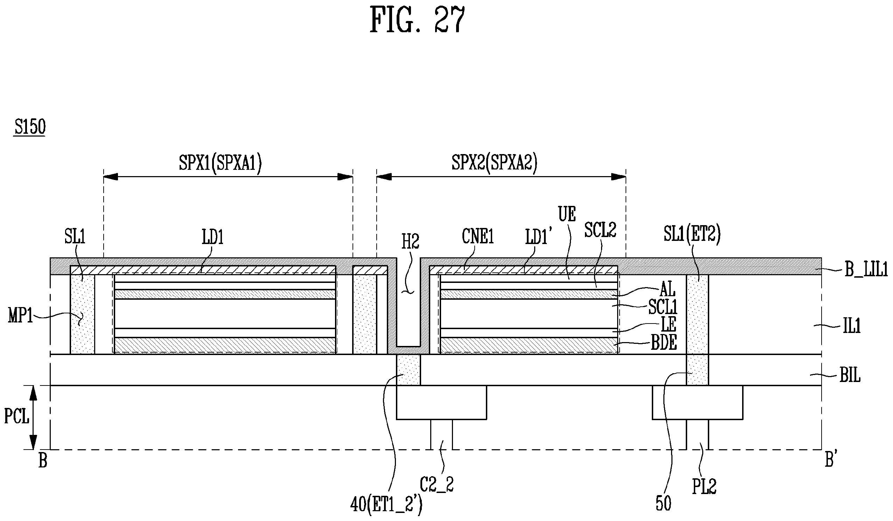

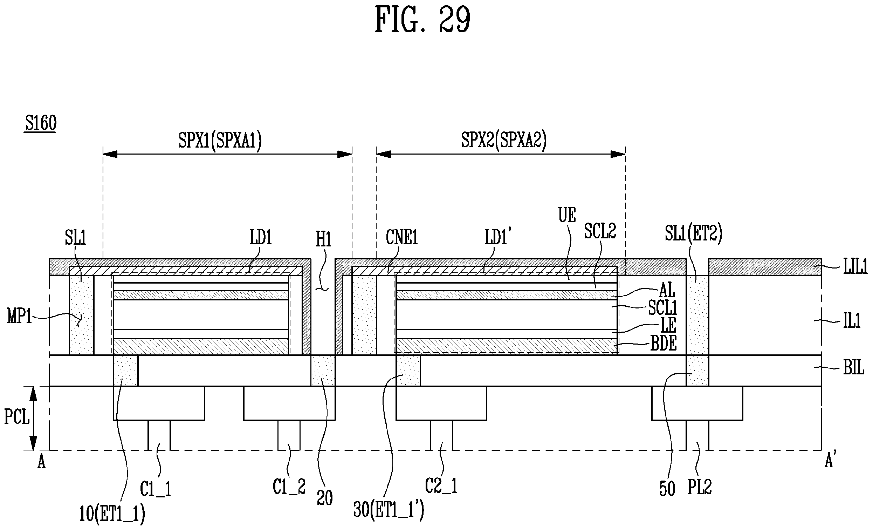

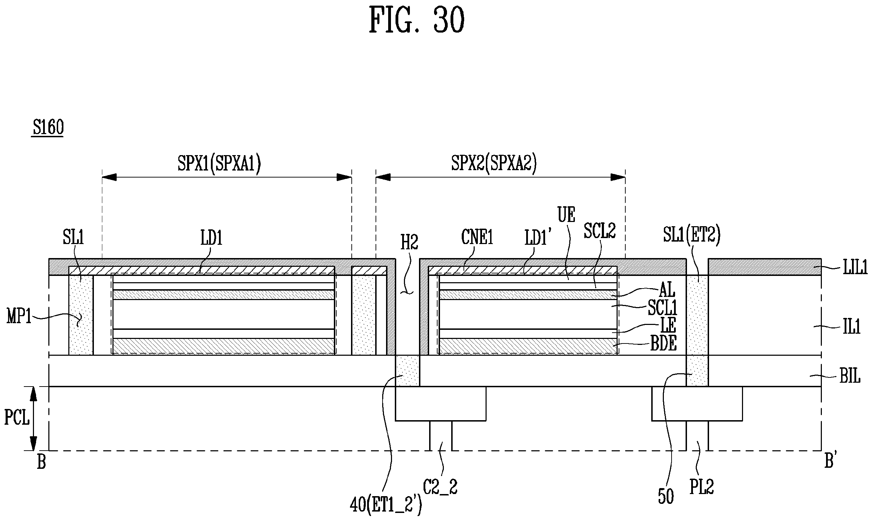

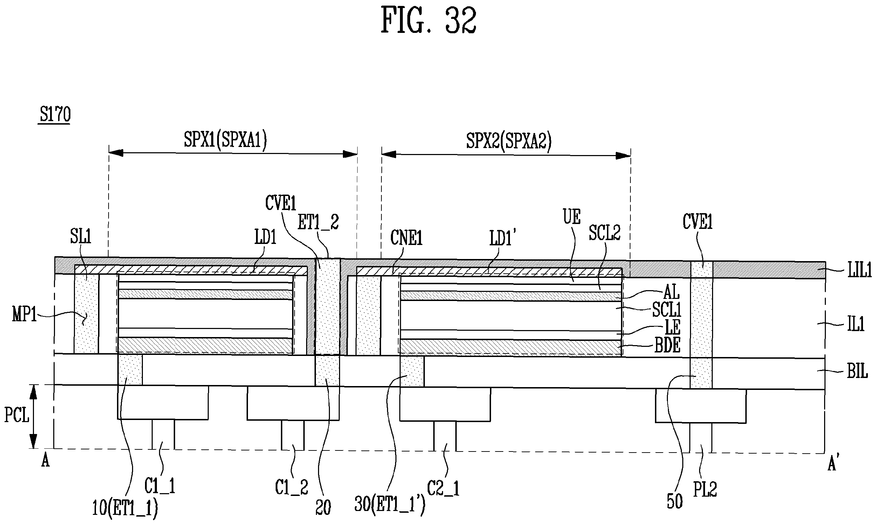

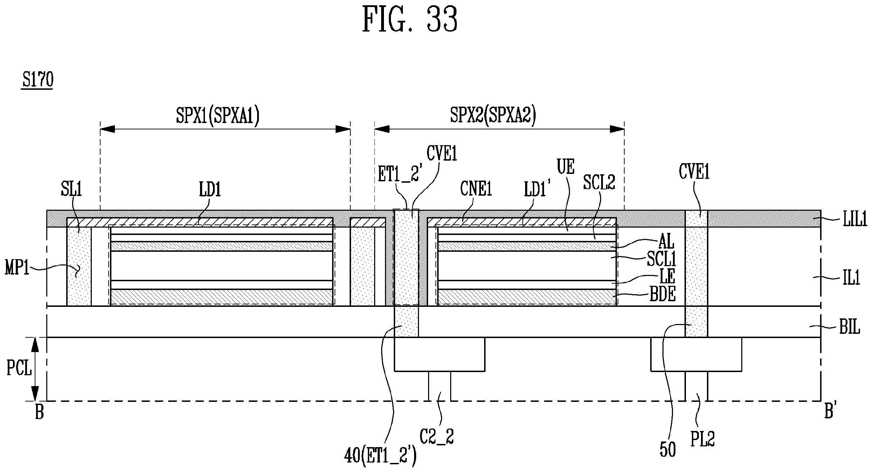

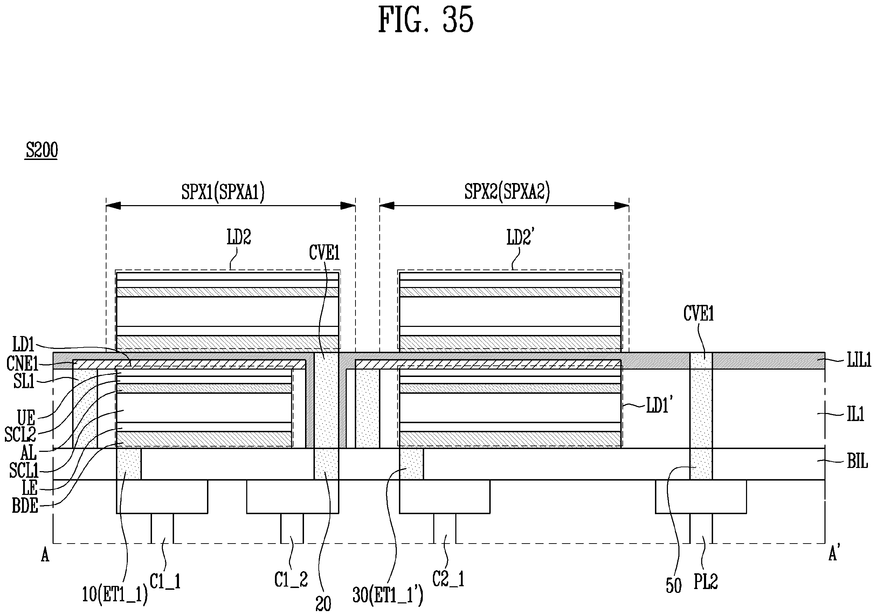

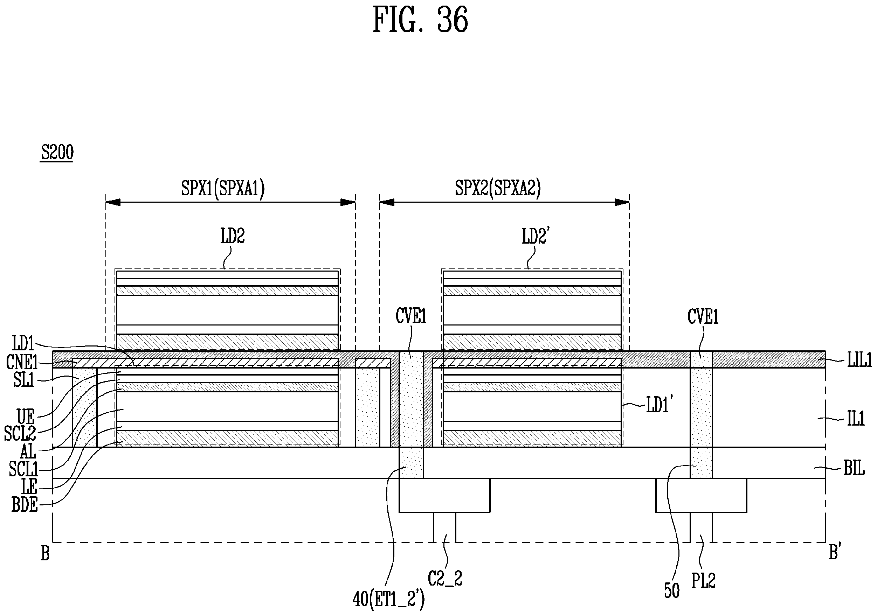

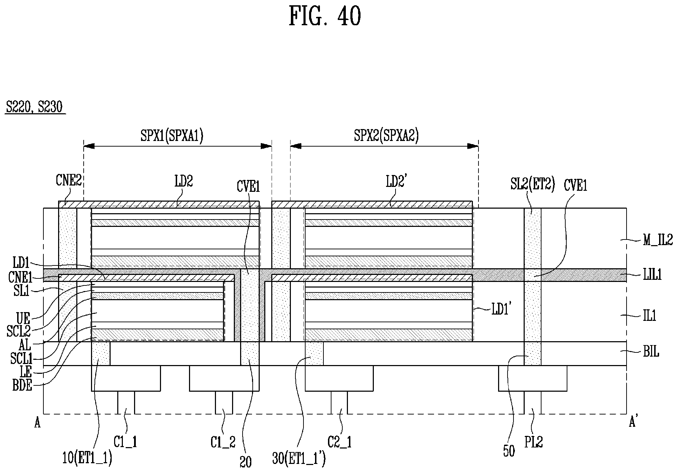

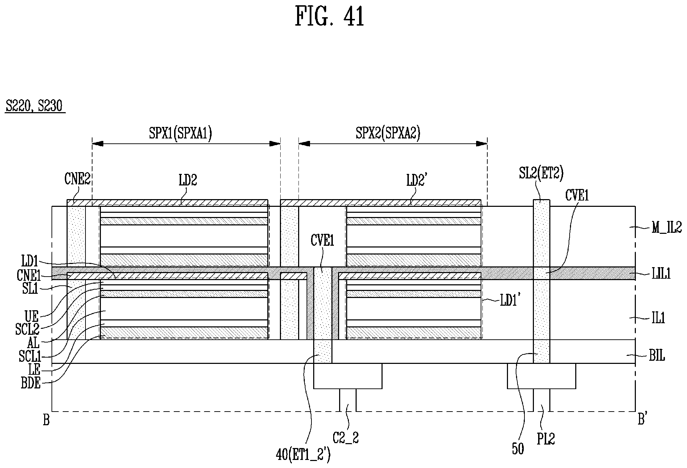

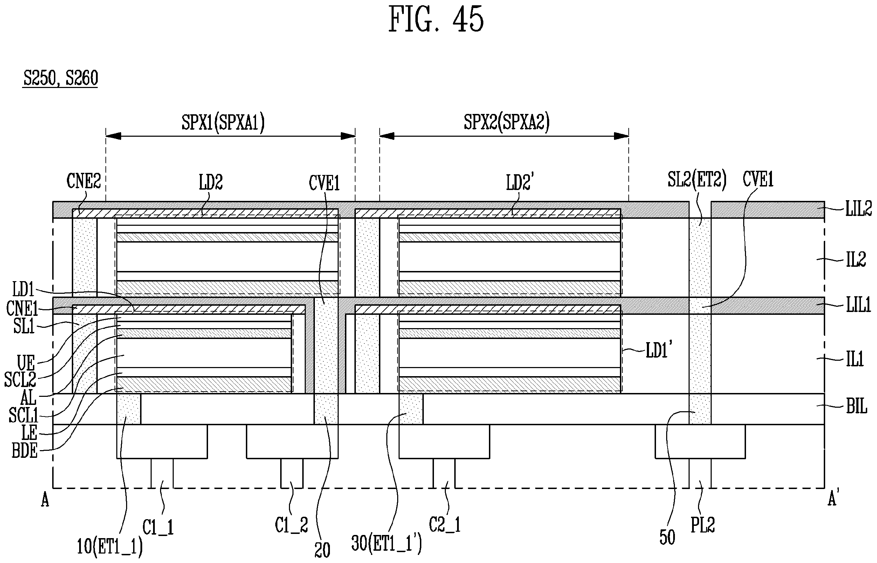

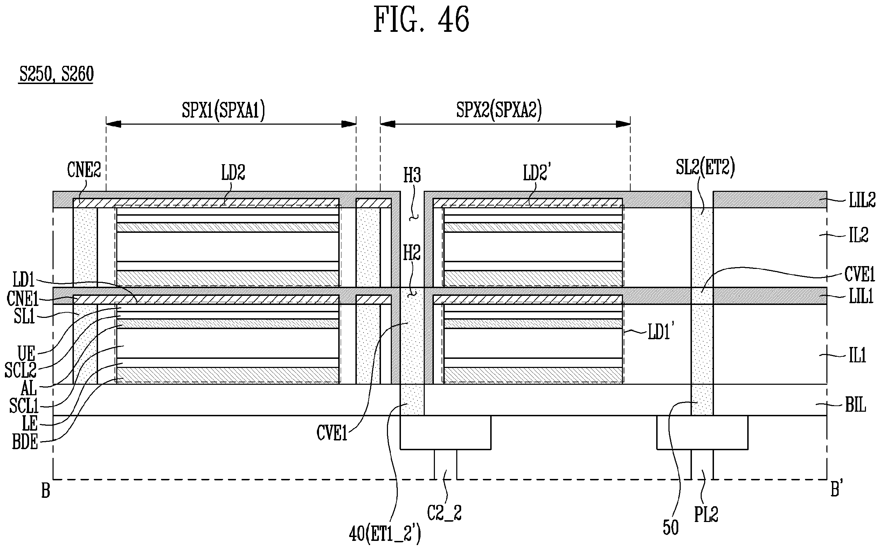

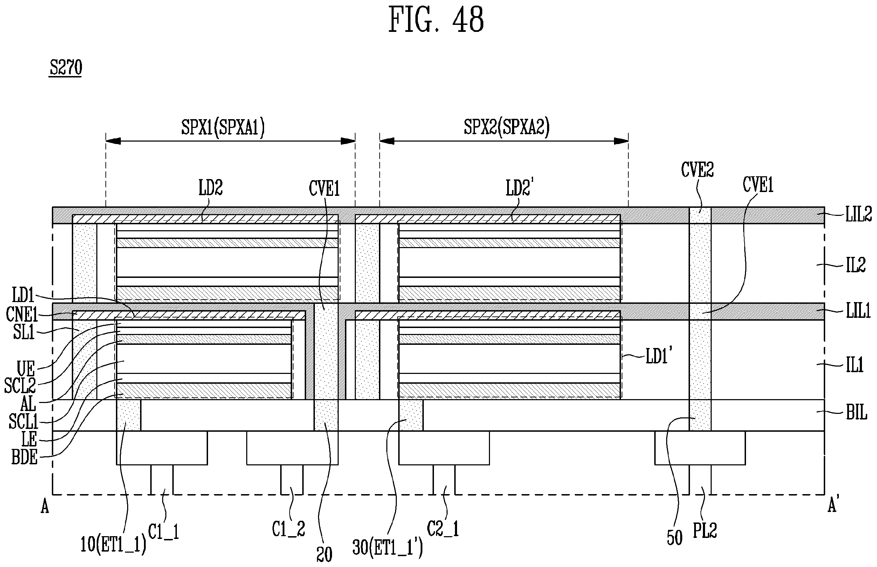

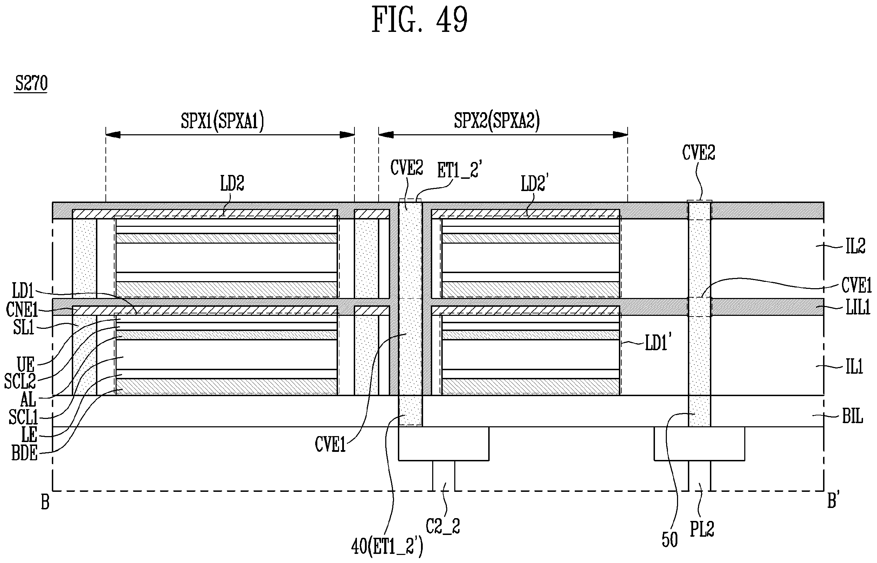

Hereinafter, a method of manufacturing a display device DD will be described with reference to FIGS. 7 to 55. The contents that may overlap the above-described contents will be briefly described or omitted.

FIGS. 7 to 55 are schematic views of each process operation for describing the method of manufacturing the display device. In FIGS. 7 to 55, some the drawings are schematic plan views of one area of the display device DD, some drawings are schematic cross-sectional views taken along the line A to A' of the display device DD, and the remaining drawings are schematic cross-sectional views taken along the line B-B' of the display device DD.

Referring to FIGS. 7 to 12, operation S100 of forming a 1-1 light-emitting element LD1 and a 2-1 light-emitting element LD1' is shown. The method of manufacturing the display device DD may include operation S100 of forming the 1-1 light-emitting element LD1 and the 2-1 light-emitting element LD1'.

Before the 1-1 light-emitting element LD1 and the 2-1 light-emitting element LD1' are formed, a pixel circuit layer PCL and a base insulating layer BIL may be formed. The method of manufacturing the display device DD may include forming the pixel circuit layer PCL and the base insulating layer BIL.

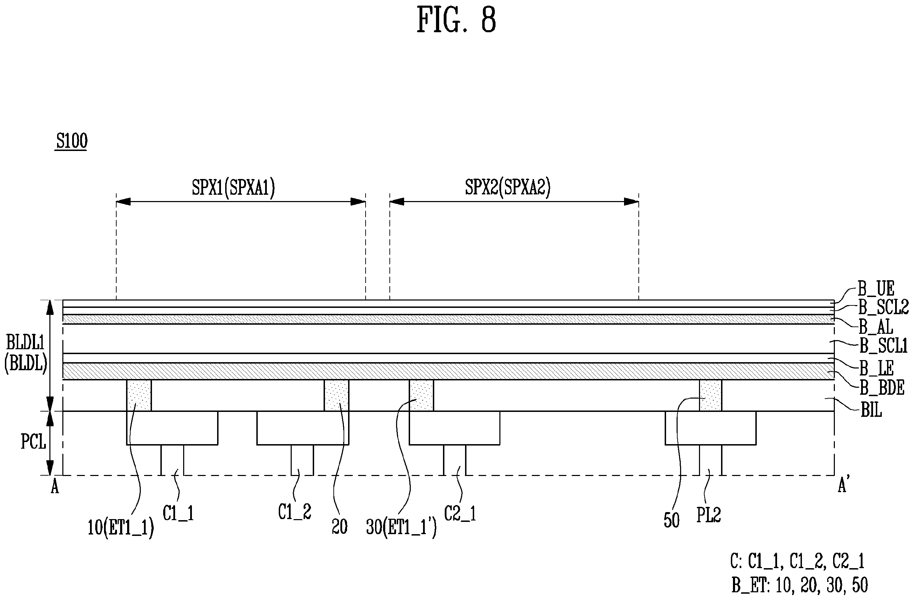

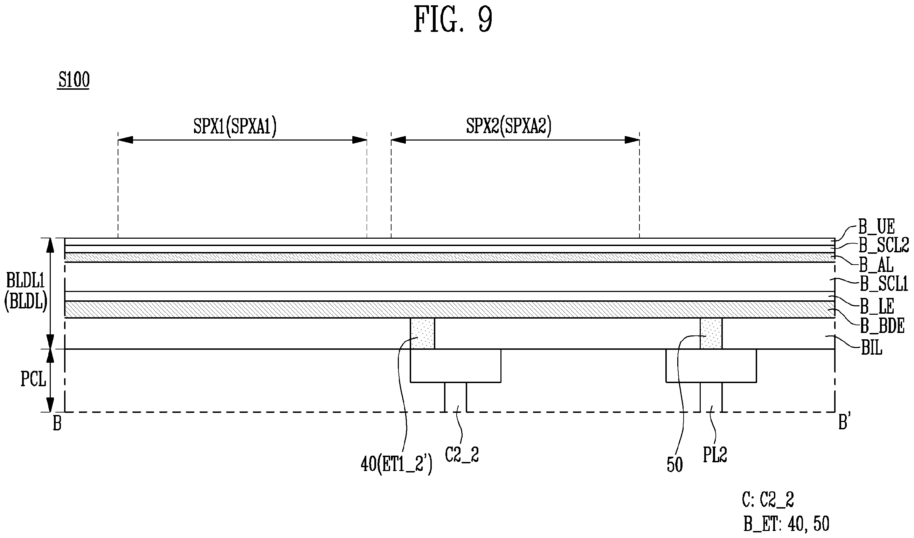

The forming of the pixel circuit layer PCL may include forming a circuit unit C and a second power line PL2. The forming of the circuit unit C may include forming a 1-1 pixel circuit unit C1_1, a 1-2 pixel circuit unit C1_2, a 2-1 pixel circuit unit C2_1, and a 2-2 pixel circuit unit C2_2. The circuit unit C may correspond to a pixel circuit PXC, and the forming of the pixel circuit layer PCL may further include forming components of the equivalent circuit diagram shown in FIG. 3 in addition to components shown in FIGS. 8 and 9.

A base insulating layer BIL may be formed on the pixel circuit layer PCL. The base insulating layer BIL may be etched to expose at least a portion of the pixel circuit layer PCL. At least a portion of the base insulating layer BIL may be etched to pass through the base insulating layer BIL to form an opening.

A base electrode layer B_ET may be formed in the opening of the base insulating layer BIL. For example, at least a portion of the base electrode layer B_ET may fill the opening of the base insulating layer BIL. The method of manufacturing the display device DD may include forming the base electrode layer B_ET.

The forming of the base electrode layer B_ET may include forming a 1-1 base electrode 10, a 1-2 base electrode 20, a 2-1 base electrode 30, a 2-2 base electrode 40, and a second base electrode 50.

The base electrode layer B_ET may include a conductive material. For example, the base electrode layer B_ET may include copper (Cu). However, it is not limited thereto.

The 1-1 base electrode 10 and the 1-2 base electrode 20 may be formed in a first subpixel area SPXA1. The 1-1 base electrode 10 may correspond to a 1-1 electrode ET1_1. For example, the 1-1 base electrode 10 may be the 1-1 electrode ET1_1. The 1-2 base electrode 20 may correspond to a portion of a 1-2 electrode ET1_2. For example, the 1-2 base electrode 20 may constitute a portion of the 1-2 electrode ET1_2.

The 2-1 base electrode 30 and the 2-2 base electrode 40 may be formed in a second subpixel area SPXA2. The 2-1 base electrode 30 may correspond to a 2-1 electrode ET1_1'. For example, the 2-1 base electrode 30 may be the 2-1 electrode ET1_1'. The 2-2 base electrode 40 may correspond to a portion of a 2-2 electrode ET1_2'. For example, the 2-2 base electrode 40 may constitute a portion of the 2-2 electrode ET1_2'.

The second base electrode 50 may be formed outside the first subpixel area SPXA1 and the second subpixel area SPXA2. The second base electrode 50 may correspond to a portion of a second electrode ET2. For example, the second base electrode 50 may constitute a portion of the second electrode ET2.

Operation S100 of forming the 1-1 light-emitting element LD1 and the 2-1 light-emitting element LD1' may include forming a base light-emitting element layer BLDL (or forming a first base light-emitting element layer BLDL1. The base light-emitting element layer BLDL may be formed over the first subpixel area SPXA1 and the second subpixel area SPXA2 (for example, on the entire surface of a display area DA).

The forming of the first base light-emitting element layer BLDL1 (or the forming of the base light-emitting element layer BLDL) may include sequentially stacking (depositing) ae base bonding electrode B_BDE, a base lower electrode B_LE, a base first semiconductor layer B_SCL1, a base active layer B_AL, a base second semiconductor layer B_SCL2, and a base upper electrode B_UE. The base bonding electrode B_BDE, the base lower electrode B_LE, the base first semiconductor layer B_SCL1, the base active layer B_AL, the base second semiconductor layer B_SCL2, and the base upper electrode B_UE may refer to a bonding electrode BDE, a lower electrode LE, a first semiconductor layer SCL1, an active layer AL, a second semiconductor layer SCL2, and an upper electrode UE before etching.

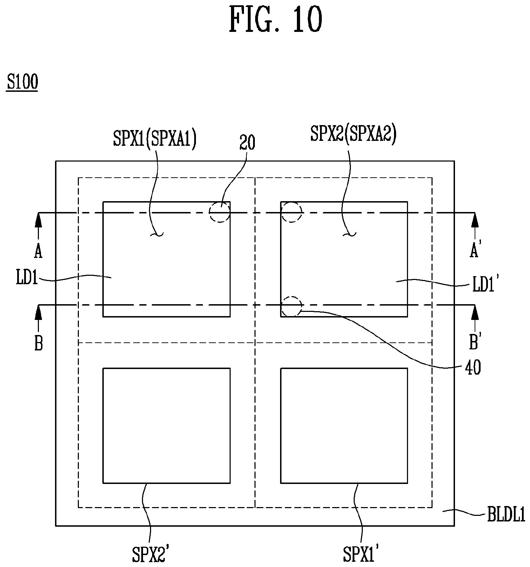

Referring to FIGS. 10 to 12, operation S100 of forming the 1-1 light-emitting element LD1 and the 2-1 light-emitting element LD1' may include etching the first base light-emitting element layer BLDL1.

In the etching of the first base light-emitting element layer BLDL1, the first base light-emitting element layer BLDL1 may be etched and formed in the first subpixel area SPXA1 and the second subpixel area SPXA2. The first base light-emitting element layer BSL1 may be etched to expose the 1-2 base electrode 20 of the first subpixel SPX1, the 2-2 base electrode 40 of the second subpixel SPX2, and the second base electrode 50.

The first base light-emitting element layer BLDL1 may be etched to form the 1-1 light-emitting element LD1 and the 2-1 light-emitting element LD1'. The 1-1 light-emitting element LD1 may not overlap the 1-2 base electrode 20 in a plan view. The 2-1 light-emitting element LD1' may not overlap the 2-2 base electrode 40 in a plan view.

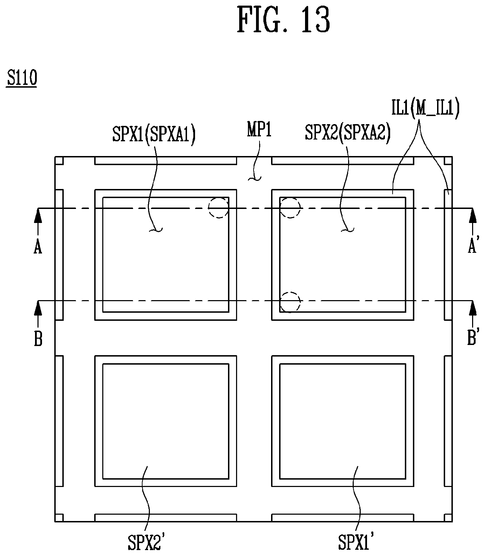

Referring to FIGS. 13 to 15, operation S110 of forming a first intermediate insulating layer is shown. The method of manufacturing the display device DD may include operation S110 of forming the first intermediate insulating layer.

Operation S110 of forming the first intermediate insulating layer may include depositing a first base insulating layer to cover the base insulating layer BIL and then etching the first base insulating layer to form the first intermediate insulating layer M_IL1. The first intermediate insulating layer M_IL1 may be an insulating layer formed by performing an etching process on the first base insulating layer once and may be an insulating layer before a first insulating layer IL1 is formed.

The first base insulating layer may be etched to form the first intermediate insulating layer M_IL1, and the first intermediate insulating layer M_IL1 (or the first insulating layer IL1) may have a first opening MP1. The first opening MP1 of the first intermediate insulating layer M_IL1 (or the first insulating layer IL1) may have a mesh pattern shape in a plan view.

The first intermediate insulating layer M_IL1 (or the first insulating layer IL1) may have the first opening MP1 exposing at least a portion of the base insulating layer BIL. The first intermediate insulating layer M_IL1 (or the first insulating layer IL1) may expose at least a portion of the base insulating layer BIL and the second base electrode 50.

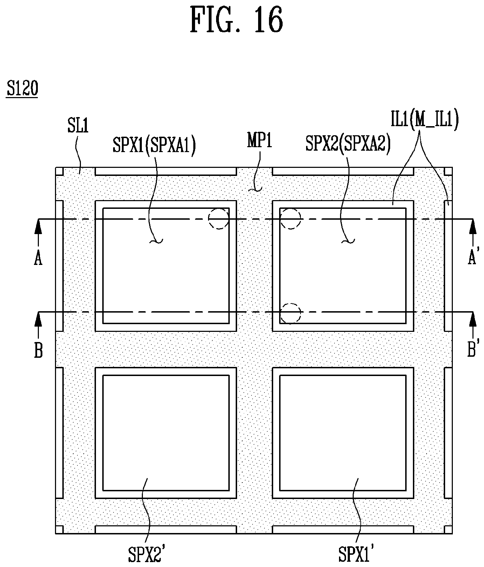

Referring to FIGS. 16 to 18, operation S120 of forming a first conductive layer is shown. The method of manufacturing the display device DD may include operation S120 of forming the first conductive layer.

Operation S120 of forming the first conductive layer S120 may include forming a first conductive layer SL1 in the first opening MP1. The first conductive layer SL1 may fill the first opening MP1.

The first conductive layer SL1 may have a mesh pattern shape in a plan view. The first conductive layer SL1 may surround the 1-1 light-emitting element LD1 and the 2-1 light-emitting element LD1'.

The first conductive layer SL1 that overlaps the second base electrode 50 in a plan view may correspond to a portion of the second electrode ET2. The first conductive layer SL1 may supply a cathode signal supplied to the second electrode ET2 to the 1-1 light-emitting element LD1 and the 2-1 light-emitting element LD1'.

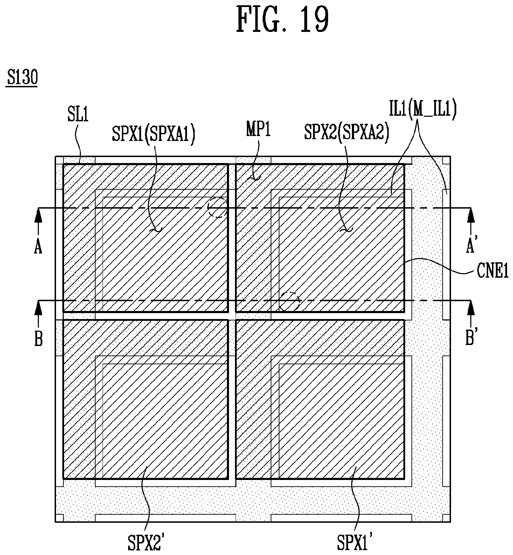

Referring to FIGS. 19 to 21, operation S130 of forming a first connection electrode is shown. The method of manufacturing the display device DD may include operation S130 of forming the first connection electrode.

A first connection electrode CNE1 may be formed on the 1-1 light-emitting element LD1 and the 2-1 light-emitting element LD1'. The first connection electrode CNE1 may be formed to be in contact with upper surfaces of the 1-1 light-emitting element LD1 and the 2-1 light-emitting element LD1'. The first connection electrode CNE1 may cover the upper surfaces of the 1-1 light-emitting element LD1 and the 2-1 light-emitting element LD1'.

The first connection electrode CNE1 may be formed to be in contact with a portion of the first conductive layer SL1. For example, the first connection electrode CNE1 may be formed to be in contact with a portion of the first conductive layer SL1 that does not overlap the second base electrode 50 in a plan view. The first connection electrode CNE1 may not overlap the second base electrode 50 in a plan view.

The first connection electrode CNE1 may be connected to the 1-1 light-emitting element LD1, the 2-1 light-emitting element LD1', and a portion of the first conductive layer SL1. The first connection electrode CNE1 may electrically connect the second electrode ET2 to the 1-1 light-emitting element LD1 and the 2-1 light-emitting element LD1'.

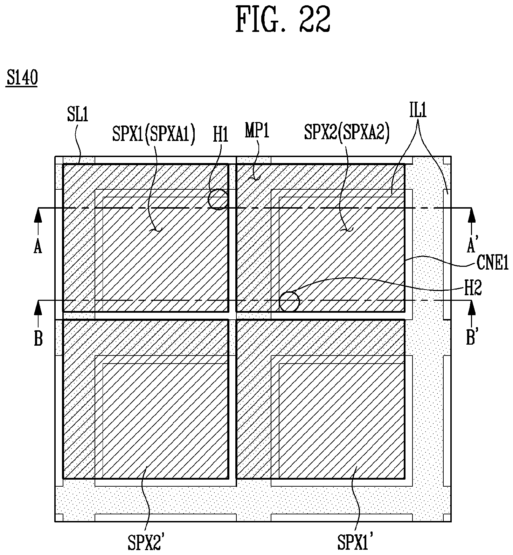

Referring to FIGS. 22 to 24, operation S140 of forming a first contact opening and a second contact opening is shown. The method of manufacturing the display device DD may include operation S140 of forming the first contact opening and the second contact opening.

Although FIG. 22 illustrates that a first contact opening H1 is formed at a right upper end portion of the first subpixel area SPXA1, and the second contact opening H2 is formed at a left lower end portion of the second subpixel area SPXA2, positions of the first contact opening H1 and the second contact opening H2 are not limited thereto.

Operation S140 of forming the first contact opening and the second contact opening may include etching the first intermediate insulating layer M_IL1. The first intermediate insulating layer M_IL1 may be etched to form the first contact opening H1 and the second contact opening H2, and the first intermediate insulating layer M_IL1 may be etched to form the first insulating layer IL1.

The first contact opening H1 may be formed in the first subpixel area SPXA1. The first contact opening H1 may expose the 1-2 base electrode 20. The second contact opening H2 may be formed in the second subpixel area SPXA2. The second contact opening H2 may expose the 2-2 base electrode 40.

The first contact opening H1 and the second contact opening H2 may be filled with a conductive material later to function as contact portions through which some (for example, a 1-2 light-emitting element LD2 and a 2-3 light-emitting element LD3') of light-emitting elements LD located on the 1-1 light-emitting element LD1 and the 2-1 light-emitting element LD1' are electrically connected to a pixel circuit PXC. This will be described below with reference to the drawings.

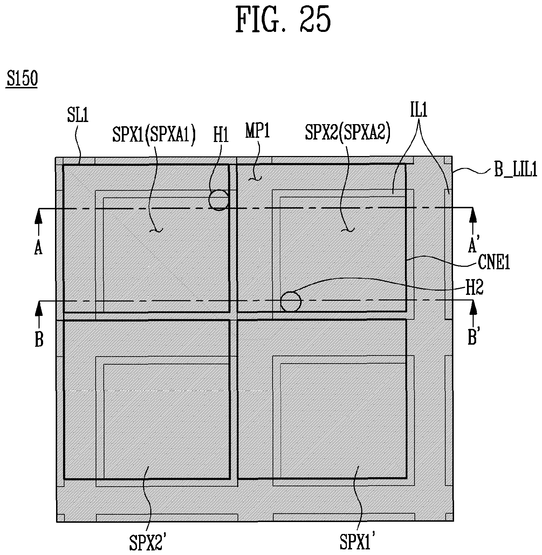

Referring to FIGS. 25 to 27, operation S150 of forming a first base interlayer insulating layer is shown. The method of manufacturing the display device DD may include operation S510 of forming the first base interlayer insulating layer.

Operation S150 of forming the first base interlayer insulating layer may include forming the first base interlayer insulating layer B_LIL1 to entirely cover the 1-1 light-emitting element LD1 and the 2-1 light-emitting element LD1'. The first base interlayer insulating layer B_LIL1 may entirely cover upper surfaces of the 1-1 light-emitting element LD1 and the 2-1 light-emitting element LD1'.

The first base interlayer insulating layer B_LIL1 may entirely cover the first connection electrode CNE1 and the first conductive layer SL1. The first base interlayer insulating layer B_LIL1 may cover the exposed 1-2 base electrode 20, 2-2 base electrode 40, and first conductive layer SL1 (for example, a portion of the second electrode ET2).

Before an etching process is performed, the first base interlayer insulating layer B_LIL1 may be etched later to form a first interlayer insulating layer LIL1.

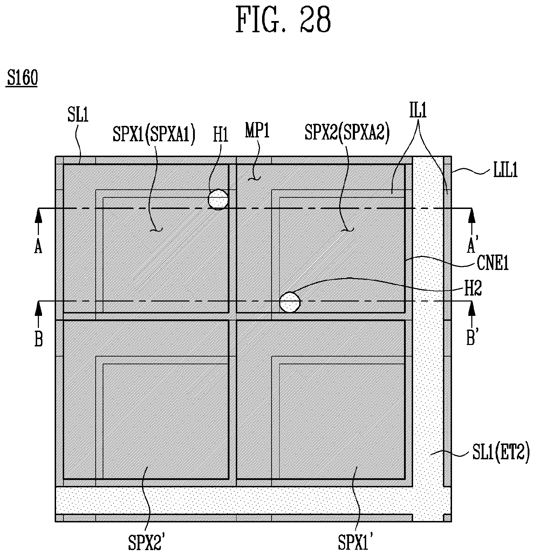

Referring to FIGS. 28 to 30, operation S160 of etching the first base interlayer insulating layer is shown. The method of manufacturing the display device DD may include operation S160 of etching the first base interlayer insulating layer.

At least a portion of the first base interlayer insulating layer B_LIL1 may be etched, and the first base interlayer insulating layer B_LIL1 may form the first interlayer insulating layer LIL1. The first interlayer insulating layer LIL1 may cover a side surface of the first insulating layer IL1 in which the first contact opening H1 and the second contact opening H2 are defined. The first base interlayer insulating layer B_LIL1 may be etched to expose the 1-2 base electrode 20, the 2-2 base electrode 40, and the first conductive layer SL1 (for example, a portion of the second electrode ET2).

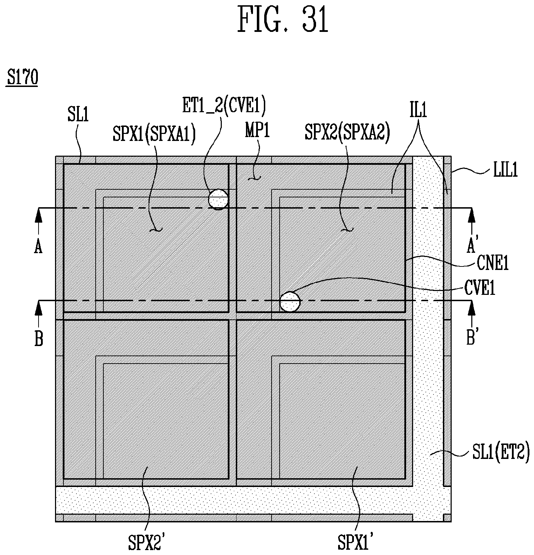

Referring to FIGS. 31 to 33, operation S170 of forming a first cover electrode is shown. The method of manufacturing the display device DD may include operation S170 of forming the first cover electrode.

A first cover electrode CVE1 may be formed in an area in which the first base interlayer insulating layer B_LIL1 is etched. For example, the first cover electrode CVE1 may be formed in an area that overlaps the area in which the first base interlayer insulating layer B_LIL1 is etched in a plan view.

The first cover electrode CVE1 may be formed to cover the first conductive layer SL1 overlapping the 1-2 base electrode 20 and the first conductive layer SL1 (for example, a portion of the electrode ET2) overlapping the second base electrode 50. The first cover electrode CVE1 may be connected (or electrically connected) to the 1-2 base electrode 20. The first cover electrode CVE1 may be connected (or electrically connected) to the first conductive layer SL1 (for example, a portion of the second electrode ET2) overlapping the second base electrode 50.

The first cover electrode CVE1 may be connected to the 1-2 base electrode 20 to form the 1-2 electrode ET1_2. The 1-2 electrode ET1_2 may electrically connect the 1-2 pixel circuit unit C1_2 and the 1-2 light-emitting element LD2.

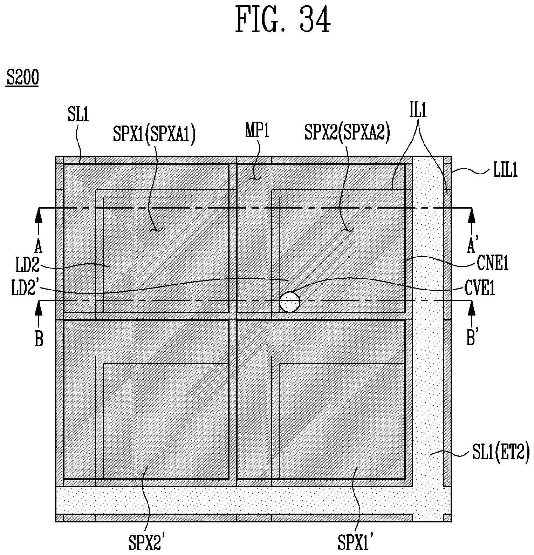

Referring to FIGS. 34 to 36, operation S200 of forming the 1-2 light-emitting element and a 2-2 light-emitting element is shown. The method of manufacturing the display device DD may include operation S200 of forming the 1-2 light-emitting element and the 2-2 light-emitting element.

Operation S200 of forming the 1-2 light-emitting element and the 2-2 light-emitting element may include forming the base light-emitting element layer BLDL described above and etching the base light-emitting element layer BLDL.

For example, a second base light-emitting element layer having the same configuration as the base light-emitting element layer BLDL may be formed on the first interlayer insulating layer LIL1, and the second base light-emitting element layer may be etched to form the 1-2 light-emitting element LD2 and the 2-2 light-emitting element LD2'.

The 1-2 light-emitting element LD2 may be etched such that at least a portion thereof is in contact with a 1-2 electrode ET1-2. The 2-2 light-emitting element LD2' may be formed such that a lower surface thereof is completely in contact with the first interlayer insulating layer LIL1. The 2-2 light-emitting element LD2' may be etched so as not to be in contact with a portion of the first cover electrode CVE1 located in the second subpixel area SPXA2. For example, the second base light-emitting element layer may be etched to overlap the 1-2 electrode ET1-2 located in the first subpixel area SPXA1 in a plan view and may not overlap a portion of the first cover electrode CVE1 located in the second subpixel area SPXA2.

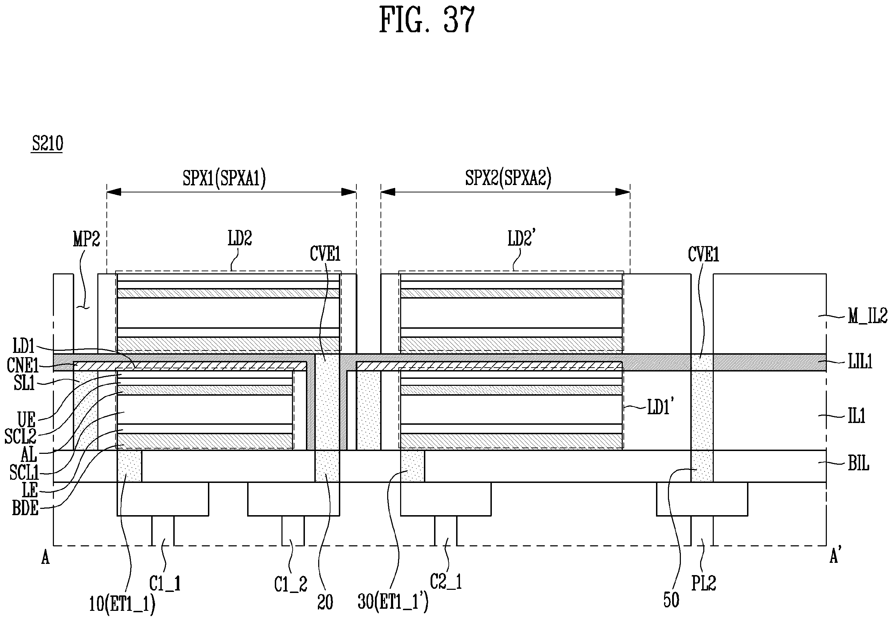

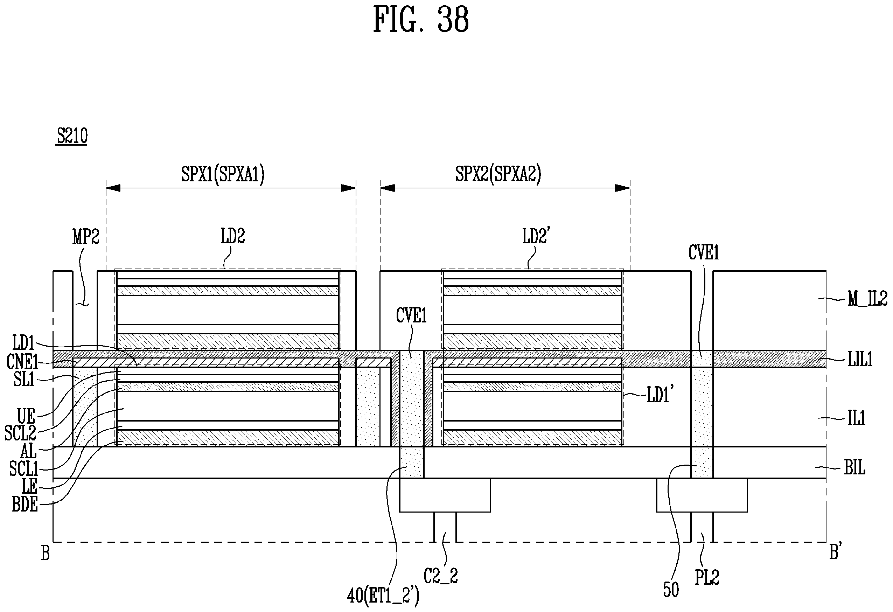

Referring to FIGS. 37 and 38, operation S210 of forming a second intermediate insulating layer is shown. The method of manufacturing the display device DD may include operation S210 of forming the second intermediate insulating layer.

Operation S210 of forming the second intermediate insulating layer may include depositing a second base insulating layer to cover the first interlayer insulating layer LIL1 and then etching the second base insulating layer to form a second intermediate insulating layer M_IL2. The second intermediate insulating layer M_IL2 may be an insulating layer formed by performing an etching process on the second base insulating layer once and may be an insulating layer before a second insulating layer IL2 is formed.

The second base insulating layer may be etched to form the second intermediate insulating layer M_IL2, and the second intermediate insulating layer M_IL2 (or the second insulating layer IL2) may have a second opening MP2. The second opening MP2 of the second intermediate insulating layer M_IL2 (or the second insulating layer IL2) may have a shape corresponding to the first opening MP1. For example, the second opening MP2 of the second intermediate insulating layer M_IL2 (or the second insulating layer IL2) may have a mesh pattern shape in a plan view.

The second intermediate insulating layer M_IL2 (or the second insulating layer IL2) may have the second opening MP2 exposing at least a portion of the first interlayer insulating layer LIL1 and a portion of the first cover electrode CVE1 (for example, a portion of the second electrode ET2) overlapping the second base electrode 50. The second intermediate insulating layer (M_IL2) (or the second insulating layer IL2) may expose a portion of the base insulating layer BIL overlapping the first conductive layer SL1 in a plan view and a portion of the cover electrode CVE1 (for example, a portion of the second electrode ET2) overlapping the second base electrode 50.

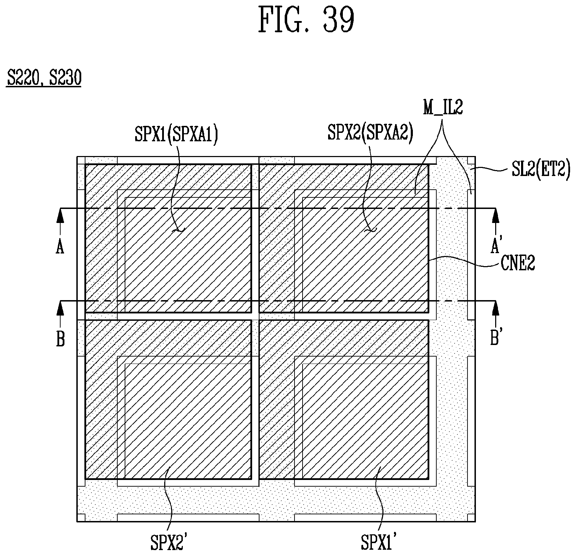

Referring to FIGS. 39 to 41, operation S220 of forming a second conductive layer and operation S230 of forming a second connection electrode are shown. The method of manufacturing the display device DD may include operation S220 of forming the second conductive layer and operation S 230 of forming the second connection electrode.

Operation S220 of forming the second conductive layer may include forming a second conductive layer SL2 in the second opening MP2. The second conductive layer SL2 may fill the second opening MP2.

The second conductive layer SL2 may have a mesh pattern shape in a plan view. The second conductive layer SL2 may surround the 1-2 light-emitting element LD2 and the 2-2 light-emitting element LD2'.

The second conductive layer SL2 that overlaps the second base electrode 50 in a plan view may correspond to a portion of the second electrode ET2. The second conductive layer SL2 may supply a cathode signal supplied to the second electrode ET2 to the 1-2 light-emitting element LD2 and the 2-2 light-emitting element LD2'.

The second connection electrode CNE2 may be formed on the 1-2 light-emitting element LD2 and the 2-2 light-emitting element LD2'. The second connection electrode CNE2 may be formed to be in contact with upper surfaces of the 1-2 light-emitting element LD2 and the 2-2 light-emitting element LD2'. The second connection electrode CNE2 may cover the upper surfaces of the 1-2 light-emitting element LD2 and the 2-2 light-emitting element LD2'.

The second connection electrode CNE2 may be formed to be in contact with a portion of the second conductive layer SL2. For example, the second connection electrode CNE2 may be formed to in contact with a portion of the second conductive layer SL2 that does not overlap the second base electrode 50 in a plan view. The second connection electrode CNE2 may not overlap the second base electrode 50 in a plan view.

The second connection electrode CNE2 may be connected to the 1-2 light-emitting element LD2, the 2-2 light-emitting element LD2', and a portion of the second conductive layer SL2. The second connection electrode CNE2 may electrically connect the second electrode ET2 to the 1-2 light-emitting element LD2 and the 2-2 light-emitting element LD2'.

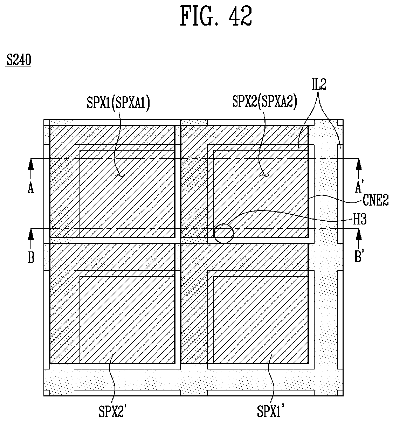

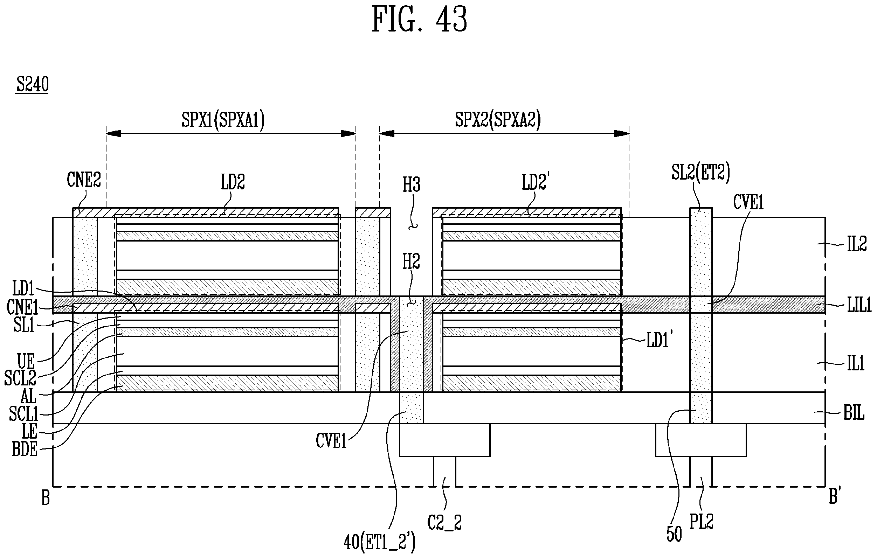

Referring to FIGS. 42 and 43, operation S240 of forming a third contact opening is shown. The method of manufacturing the display device DD may include operation S240 of forming the third contact opening.

Operation S240 of forming the third contact opening may include etching the second intermediate insulating layer M_IL2. The second intermediate insulating layer M_IL2 may be etched to form the third contact opening H3, and the second intermediate insulating layer M_IL2 may be etched to form the second insulating layer IL2.

The third contact opening H3 may be formed in the second subpixel area SPXA2. The third contact opening H3 may overlap the second contact opening H2 in a plan view. The third contact opening H3 may expose a portion of the first cover electrode CVE1 formed in the second contact opening H2.

The third contact opening H3 may be filled with a conductive material later to function as a contact through which the 2-3 light-emitting element LD3' located on the 2-2 light-emitting element LD2' is electrically connected to the pixel circuit PXC. This will be described below with reference to the drawings.

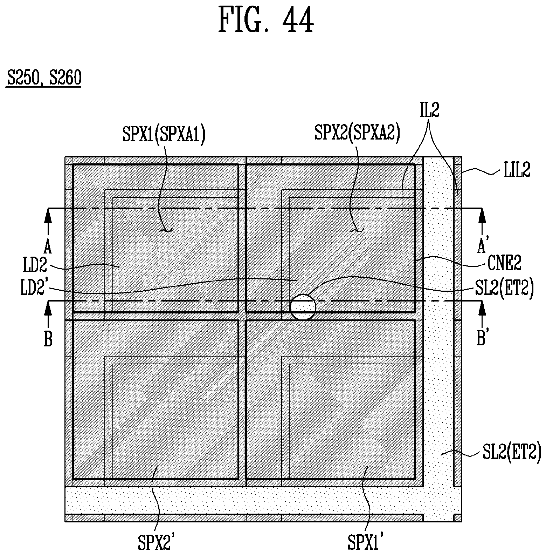

Referring to FIGS. 44 to 46, forming of a second interlayer insulating layer LIL2 is shown. The method of manufacturing the display device DD may include the forming of the second interlayer insulating layer LIL2.

The forming of the second interlayer insulating layer LIL2 may include operation S250 of forming a second base interlayer insulating layer and operation S260 of etching the second base interlayer insulating layer.

Operation S250 of forming the second base interlayer insulating layer may include forming the second base interlayer insulating layer to entirely cover the 1-2 light-emitting element LD2 and the 2-2 light-emitting element LD2'. The second base interlayer insulating layer may entirely cover the upper surfaces of the 1-2 light-emitting element LD2 and the 2-1 light-emitting element LD2'.

Before the etching process is performed, the second base interlayer insulating layer may be etched later to form the second interlayer insulating layer LIL2.

At least a portion of the second base interlayer insulating layer may be etched, and the second base interlayer insulating layer may form the second interlayer insulating layer LIL2. The second base interlayer insulating layer may be etched to expose the first cover electrode CVE1 overlapping the 2-2 base electrode 40 in a plan view, and the second conductive layer SL2 (for example, a portion of the second electrode ET2) overlapping the second base electrode 50 in a plan view.

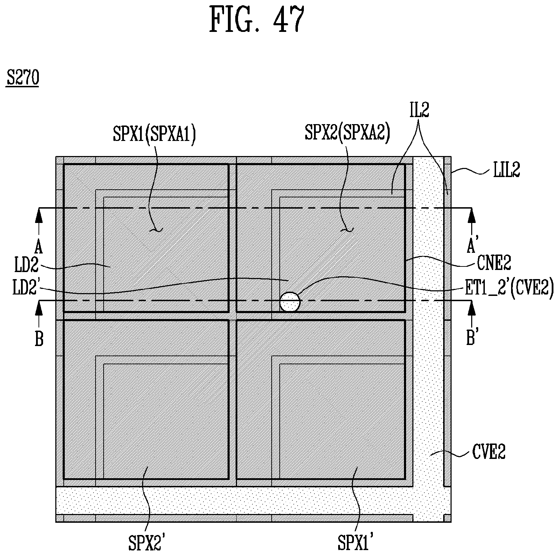

Referring to FIGS. 47 to 49, operation S270 of forming a second cover electrode is shown. The method of manufacturing the display device DD may include operation S270 of forming the second cover electrode.

The second cover electrode CVE2 may be formed in an area in which the second base interlayer insulating layer is etched. For example, the second cover electrode CVE2 may be formed in an area that overlaps the area, in which the second base interlayer insulating layer is etched, in a plan view.

The second cover electrode CVE2 may be formed to cover the first cover electrode CVE1 overlapping the 2-2 base electrode 40 in a plan view, and the second conductive layer SL2 (for example, a portion of the second electrode ET2) overlapping the second base electrode 50 in a plan view. The second cover electrode CVE2 may be connected (or electrically connected) to the 2-2 base electrode 40. The second cover electrode CVE2 may be connected (or electrically connected) to the second conductive layer SL2 (for example, a portion of the second electrode ET2) overlapping the second base electrode 50.

The second cover electrode CVE2 may be connected to the 2-2 base electrode 40 to form the 2-2 electrode ET1_2'. The 2-2 electrode ET1_2' may electrically connect the 2-2 pixel circuit unit C2_2 and the 2-3 light-emitting element LD3'.

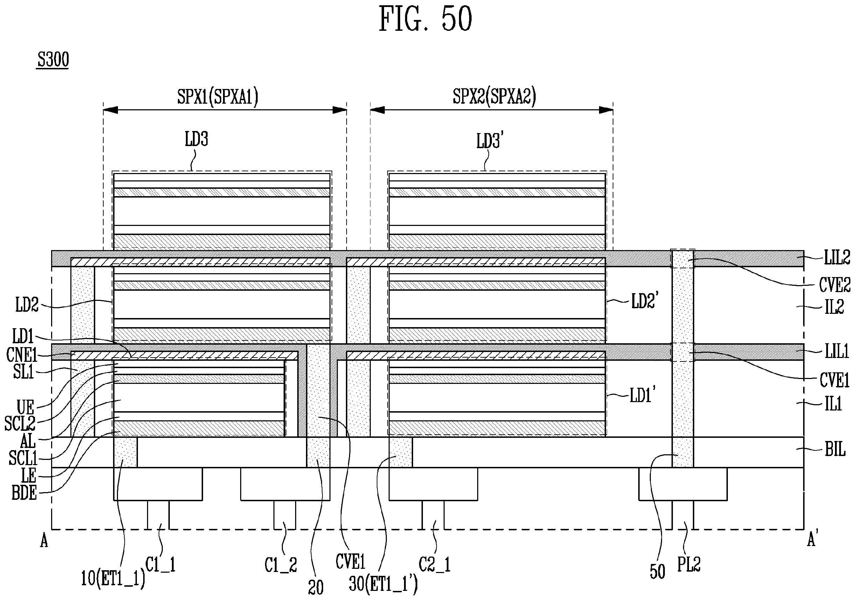

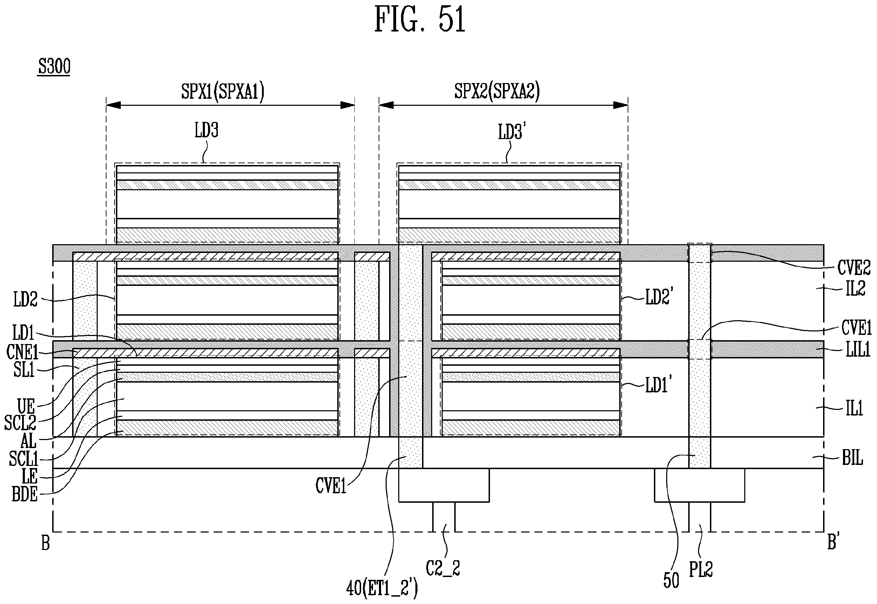

Referring to FIGS. 50 and 51, operation S300 of forming a 1-3 light-emitting element and the 2-3 light-emitting element is shown. The method of manufacturing the display device DD may include operation S300 of forming the 1-3 light-emitting element and the 2-3 light-emitting element.

Operation S300 of forming the 1-3 light-emitting element and the 2-3 light-emitting element may include forming the base light-emitting element layer BLDL described above and etching the base light-emitting element layer BLDL.

For example, a third base light-emitting element layer having the same structure as the base light-emitting element layer BLDL may be formed on the second interlayer insulating layer LIL2, and the third base light-emitting element layer may be etched to form the 1-3 light-emitting element LD3 and the 2-3 light-emitting element LD3'.

The 2-3 light-emitting element LD3' may be etched to be in contact with the 2-2 electrode ET1_2'. The 2-3 light-emitting element LD3' may be electrically connected to the 2-2 electrode ET1_2'. The 1-3 light-emitting element LD3 may be formed such that a lower surface of the 1-3 light-emitting element LD3 is completely in contact with the second interlayer insulating layer LIL2.

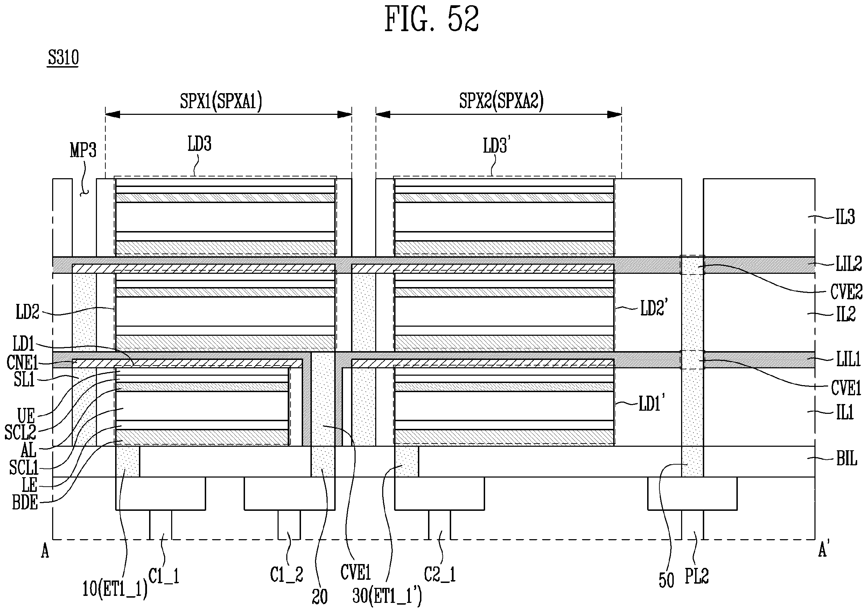

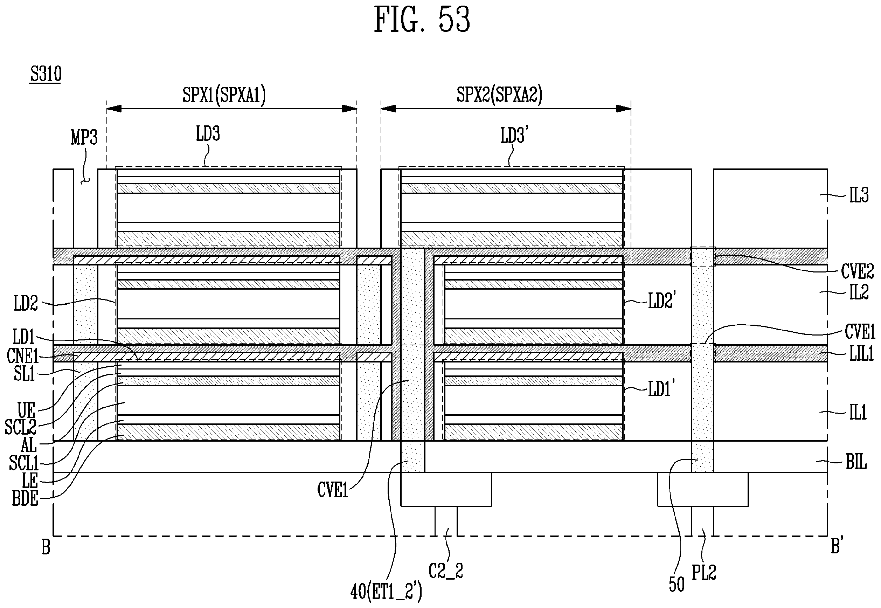

Referring to FIGS. 52 and 53, operation S310 of forming a third insulating layer is shown. The method of manufacturing the display device DD may include operation S310 of forming the third insulating layer.

Operation S310 of forming the third insulating layer may include depositing a third base insulating layer to cover the second interlayer insulating layer LIL2 and then etching the third base insulating layer to form a third insulating layer IL3.

The third base insulating layer may be etched to form the third insulating layer IL3, and the third insulating layer IL3 may have a third opening MP3. The third opening MP3 may have a shape corresponding to the first opening MP1 and the second opening MP2. For example, the third opening MP3 may have a mesh pattern shape in a plan view.

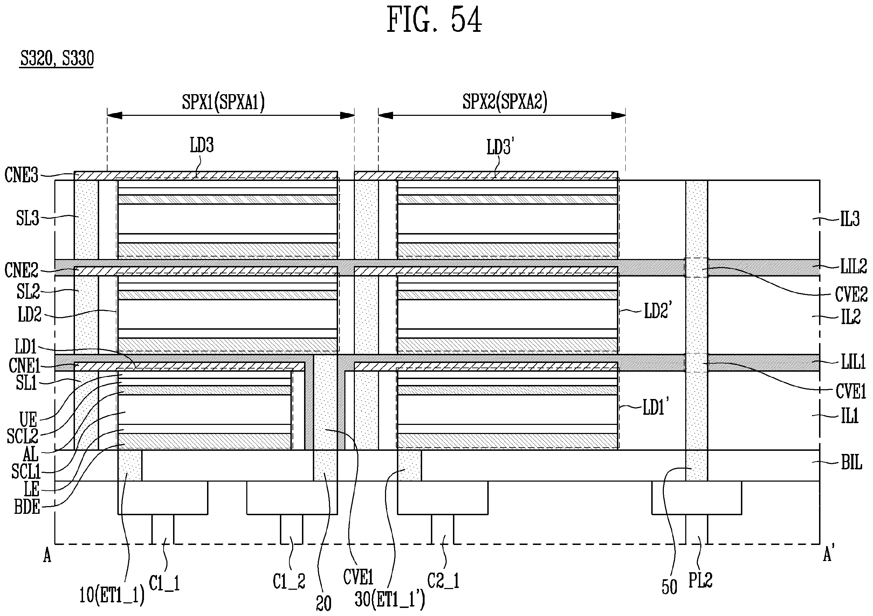

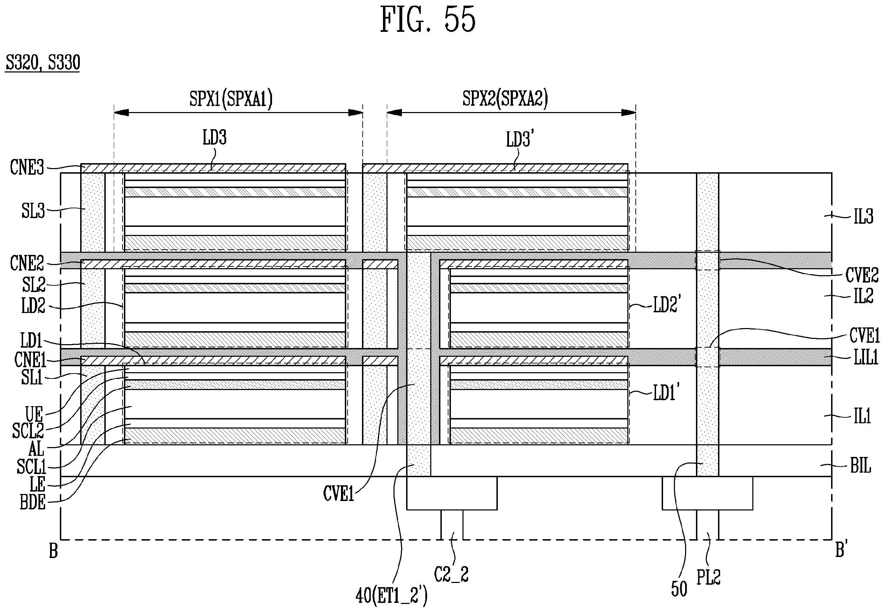

Referring to FIGS. 54 and 55, operation S320 of forming a third conductive layer and operation S330 of forming a third connection electrode. The method of manufacturing the display device DD may include operation S320 of forming the third conductive layer and operation S330 of forming the third connection electrode.

Operation S320 of forming the third conductive layer may include forming a third conductive layer SL3 in the third opening MP3. The third conductive layer SL3 may fill the third opening MP3.

The third conductive layer SL3 may have a mesh pattern shape in a plan view. The third conductive layer SL3 may surround the 1-3 light-emitting element LD3 and the 2-3 light-emitting element LD3'.

The third conductive layer SL3 that overlaps the second base electrode 50 in a plan view may correspond to a portion of the second electrode ET2. The third conductive layer SL3 may supply a cathode signal supplied to the second electrode ET2 to the 1-3 light-emitting element LD3 and the 2-3 light-emitting element LD3'.

The third conductive layer SL3 may be connected to the second base electrode 50, the first conductive layer SL1, a portion of the first cover electrode CVE1, the second conductive layer SL2, and a portion of the second cover electrode CVE2 to form the second electrode ET2. The second electrode ET2 may be formed to pass through the first insulating layer IL1, the second insulating layer IL2, and the third insulating layer IL3.

The third connection electrode CNE3 may be formed on the 1-3 light-emitting element LD3 and the 2-3 light-emitting element LD3'. The third connection electrode CNE3 may be formed to be in contact with upper surfaces of the 1-3 light-emitting element LD3 and the 2-3 light-emitting element LD3'. The third connection electrode CNE3 may cover the upper surfaces of the 1-3 light-emitting elements LD3 and 2-3 light-emitting elements LD3'.

The third connection electrode CNE3 may be formed to be in contact with the 1-3 light-emitting element LD3, the 2-3 light-emitting element LD3', and a portion of the third conductive layer SL3. For example, the third connection electrode CNE3 may be formed to be in contact with a portion of the third conductive layer SL3 that does not overlap the second base electrode 50 in a plan view. The third connection electrode CNE3 may not overlap the second base electrode 50 in a plan view.

The third connection electrode CNE3 may be connected to the 1-3 light-emitting element LD3, the 2-3 light-emitting element LD3', and a portion of the third conductive layer SL3. The third connection electrode CNE3 may electrically connect the second electrode ET2 to the 1-3 and the 2-3 light-emitting elements LD3 and LD3'.

Thereafter, after the third connection electrode CNE3 is formed, an insulating layer may be additionally deposited to entirely cover the third connection electrode CNE3 and the third insulating layer IL3.

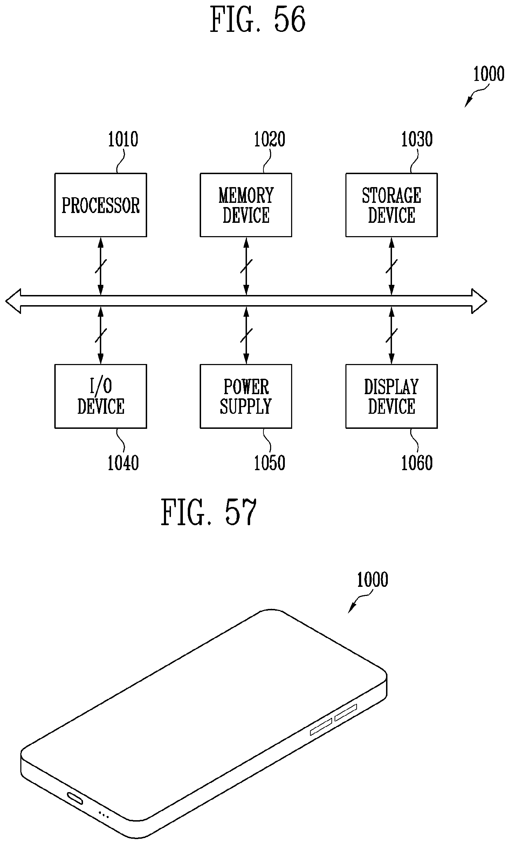

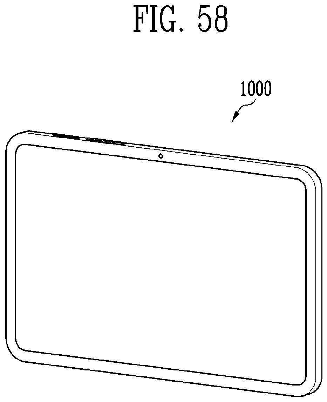

FIG. 56 is a schematic block diagram illustrating an electronic device 1000 including a display device. FIG. 57 is a schematic diagram illustrating an example where the electronic device 1000 of FIG. 56 is a smartphone. FIG. 58 is a schematic diagram illustrating an example where the electronic device 1000 of FIG. 56 is a tablet computer.

Referring to FIGS. 56 to 58, the electronic device 1000 may include a processor 1010, a memory device 1020, a storage device 1030, an input/output (I/O) device 1040, a power supply 1050, and a display device 1060. The display device 1060 may be the display device DD of FIG. 1. The electronic device 1000 may further include various ports for communication with a video card, a sound card, a memory card, a USB device, or other systems. As illustrated in FIG. 57, the electronic device 1000 may be a smartphone. As illustrated in FIG. 58, the electronic device 1000 may be a tablet computer. However, the aforementioned examples are illustrative, and the electronic device 1000 is not necessarily limited to the aforementioned examples. For example, the electronic device 1000 may be a cellular phone, a video phone, a smart pad, a smartwatch, a navigation device for vehicles, a computer monitor, a laptop computer, a head-mounted display device, or the like.

The processor 1010 may perform specific calculations or tasks. The processor 1010 may include at least one of a central processing unit, an application processor, a graphic processing unit, a communication processor, an image signal processor, a controller, or the like. The processor 1010 may be connected to other components through an address bus, a control bus, a data bus, and the like. The processor 1010 may be connected to an expansion bus such as a peripheral component interconnect (PCI) bus. The processor 1010 may provide input image data to the display device 1060. Hence, the display device 1060 may display an image based on the input image data provided from the processor 1010.

The memory device 1020 may store data needed to perform the operation of the electronic device 1000. The memory device 1020 may function as a working memory and/or a buffer memory for the processor 1010. For example, the memory device 1020 may include one or more volatile memory devices such as a dynamic random access memory (DRAM) device, a static random access memory (SRAM) device, and a mobile DRAM device.

The storage device 1030 may store data in response to control signals or data from the processor 1010. The storage device 1030 may include one or more non-volatile storages to retain the data even when the electronic device 1000 is powered off. The storage device 1030 may include a solid state drive (SSD), a hard disk drive (HDD), a CD-ROM, or the like.

The I/O device 1040 may include input devices such as a keyboard, a keypad, a touchpad, a touch screen, and a mouse, and output devices such as a speaker and a printer. The display device 1060 may be integrated with the I/O device 1040.

The power supply 1050 may supply power needed to perform the operation of the electronic device 1000. For example, the power supply 1050 may include a power management integrated circuit (PMIC). The power supply 1050 may supply power to the display device 1060.

The display device 1060 may display images in response to image data signals and/or control signals from the processor 1010. The display device 1060 may be connected to other components through the buses or other communication links.

According to some embodiments, a display device may be capable of displaying relatively high-resolution images.

Aspects of some embodiments include a display device and a method of manufacturing the display device, which is capable of increasing light efficiency and relatively simplifying manufacturing processes.

Although the invention has been described with reference to embodiments, it will be understood by those skilled in the art or those having ordinary knowledge in the art that the present disclosure may be variously modified and changed without departing from the scope of the invention as set out in the claims.

## Claims

1. A display device comprising:
a first subpixel (SPX1);
a second subpixel (SPX2);
a pixel circuit layer (PCL) including a pixel circuit (PXC);
a first subpixel area (SPXA1) formed by the first subpixel;
a second subpixel area (SPXA2) formed by the second subpixel;
a 1-1 light-emitting element (LD1) on the pixel circuit layer, a 1-2 light-emitting element (LD2) on the 1-1 light-emitting element, and a 1-3 light-emitting element (LD3) on the 1-2 light-emitting element, wherein the 1-1 light-emitting element, the 1-2 light-emitting element, and 1-3 light-emitting element are in the first sub-pixel area; and
a 2-1 light-emitting element (LD1') on the pixel circuit layer, a 2-2 light-emitting element (LD2') on the 2-1 light-emitting element, and a 2-3 light-emitting element (LD3') on the 2-2 light-emitting element, wherein the 2-1 light-emitting element, the 2-2 light-emitting element, and the 2-3 light-emitting element are in the second subpixel area,
wherein the 1-3 light-emitting element (LD3) is not electrically connected to the pixel circuit (PXC).

2. The display device of claim 1, wherein the 2-2 light-emitting element (LD2') is not electrically connected to the pixel circuit, and
the 1-1 light-emitting element (LD1), the 1-2 light-emitting element (LD2), the 2-1 light-emitting element (LD1'), and the 2-3 light-emitting element (LD3') are electrically connected to the pixel circuit.

3. The display device of claim 1 or 2, further comprising:
a 1-1 electrode configured to electrically connect the pixel circuit and the 1-1 light-emitting element;
a 1-2 electrode configured to electrically connect the pixel circuit and the 1-2 light-emitting element;
a 2-1 electrode configured to electrically connect the pixel circuit and the 2-1 light-emitting element; and
a 2-2 electrode configured to electrically connect the pixel circuit and the 2-3 light-emitting element,
wherein the 1-2 electrode does not overlap the 1-1 light-emitting element in a plan view.

4. The display device of claim 1, 2 or 3, further comprising:
a first interlayer insulating layer of which at least a portion is between the 1-1 light-emitting element and the 1-2 light-emitting element and between the 2-1 light-emitting element and the 2-2 light-emitting element; and
a second interlayer insulating layer of which at least a portion is between the 1-2 light-emitting element and the 1-3 light-emitting element and between the 2-2 light-emitting element and the 2-3 light-emitting element,
wherein the second interlayer insulating layer entirely covers a lower surface of the 1-3 light-emitting element and exposes at least a portion of a lower surface of the 2-3 light-emitting element.

5. The display device of claim 3, further comprising:
a first insulating layer surrounding the 1-1 light-emitting element and the 2-1 light-emitting element;
a second insulating layer surrounding the 1-2 light-emitting element and the 2-2 light-emitting element; and
a third insulating layer surrounding the 1-3 light-emitting element and the 2-3 light-emitting element,
wherein the 1-2 electrode passes through the first insulating layer, and
the 2-2 electrode passes through the first insulating layer and the second insulating layer.

6. The display device of claim 1 or 2, further comprising a first electrode and a second electrode electrically connected to the pixel circuit,
wherein the second electrode does not overlap the 1-1 light-emitting element and the 2-1 light-emitting element in a plan view,
the first electrode is an anode, and
the second electrode is a cathode.

7. The display device of claim 6, further comprising:
a first insulating layer surrounding the 1-1 light-emitting element and the 2-1 light-emitting element;
a second insulating layer surrounding the 1-2 light-emitting element and the 2-2 light-emitting element; and
a third insulating layer surrounding the 1-3 light-emitting element and the 2-3 light-emitting element,
wherein the second electrode passes through the first insulating layer, the second insulating layer, and the third insulating layer.

8. The display device of claim 6 or 7, further comprising:
a first conductive layer configured to electrically connect the second electrode and the 1-1 light-emitting element;
a second conductive layer configured to electrically connect the second electrode and the 1-2 light-emitting element; and
a third conductive layer configured to electrically connect the second electrode and the 1-3 light-emitting element,
wherein each of the first conductive layer, the second conductive layer, and the third conductive layer includes the same material as at least a portion of the second electrode.

9. The display device of claim 8, wherein each of the first conductive layer, the second conductive layer, and the third conductive layer is integrally connected to the second electrode, and
the first conductive layer, the second conductive layer, the third conductive layer, and the second electrode have a mesh pattern shape in the plan view.

10. The display device of claim 8 or 9, wherein the first conductive layer and the second electrode are outside areas in which the 1-1 light-emitting element and the 2-1 light-emitting element are located, in the plan view.

11. The display device of claim 8, 9 or 10, further comprising:
a first connection electrode on the first conductive layer;
a second connection electrode on the second conductive layer; and
a third connection electrode on the third conductive layer,
wherein the first connection electrode covers an upper surface of the 1-1 light-emitting element,
the second connection electrode covers an upper surface of the 1-2 light-emitting element, and
the third connection electrode covers an upper surface of the 1-3 light-emitting element.

12. The display device of any one of the preceding claims, wherein the 1-1 light-emitting element and the 2-1 light-emitting element are configured to emit first light,
the 1-2 light-emitting element is configured to emit second light, and
the 2-3 light-emitting element is configured to emit third light,
wherein the first light, the second light, and the third light comprise light of different colors.

13. The display device of any one of the preceding claims, wherein:
the 2-1 light-emitting element (LD1') is at the same layer as the 1-1 light-emitting element (LD1);
the 2-2 light-emitting element (LD2') is at the same layer as the 1-2 light-emitting element (LD2); and
the 2-3 light-emitting element (LD3') is at the same layer as the 1-3 light-emitting element (LD3).

14. A method of manufacturing a display device including a first subpixel area formed by a first subpixel and a second subpixel area formed by a second subpixel, the method comprising:
forming a pixel circuit layer including a pixel circuit;
in the first subpixel area, forming a 1-1 base electrode and a 1-2 base electrode electrically connected to the pixel circuit, forming a 1-1 light-emitting element on the pixel circuit layer, forming a 1-2 light-emitting element on the 1-1 light-emitting element, and forming a 1-3 light-emitting element on the 1-2 light-emitting element; and
in the second subpixel area, forming a 2-1 base electrode and a 2-2 base electrode electrically connected to the pixel circuit, forming a 2-1 light-emitting element on the pixel circuit layer, forming a 2-2 light-emitting element on the 2-1 light-emitting element, and forming a 2-3 light-emitting element on the 2-2 light-emitting element,
wherein the 1-1 base electrode is electrically connected to the 1-1 light-emitting element,
the 1-2 base electrode is electrically connected to the 1-2 light-emitting element,
the 2-1 base electrode is electrically connected to the 2-1 light-emitting element,
the 2-2 base electrode is electrically connected to the 2-3 light-emitting element, and
the 1-3 light-emitting element is not electrically connected to the pixel circuit.

15. The method of claim 14, comprising:
forming a base insulating layer on the pixel circuit layer;
forming a first insulating layer on the base insulating layer;
forming a first interlayer insulating layer on the first insulating layer;
forming a second insulating layer on the first interlayer insulating layer; and
forming a second interlayer insulating layer on the second insulating layer,
wherein the forming of the first insulating layer includes depositing a first base insulating layer, etching the first base insulating layer to form a first contact opening exposing the 1-2 base electrode, and etching the first base insulating layer to form a second contact opening exposing the 2-2 base electrode, and
the forming of the second insulating layer includes depositing a second base insulating layer, and etching the second base insulating layer to form a third contact opening overlapping the second contact opening, optionally wherein, in the forming of the 2-2 light-emitting element, the 2-2 light-emitting element is formed such that a lower surface of the 2-2 light-emitting element is completely in contact with the first interlayer insulating layer.
